(19) Europäisches Patentamt
European Patent Office
Office européen des brevets

(11) **EP 3 116 018 B1**

(12) **EUROPEAN PATENT SPECIFICATION**

(45) Date of publication and mention of the grant of the patent:
**29.08.2018 Bulletin 2018/35**

(21) Application number: **15759335.1**

(22) Date of filing: **26.02.2015**

(51) Int Cl.:
***H01L 21/336*** *(2006.01)* ***H01L 29/786*** *(2006.01)*
***H01L 51/10*** *(2006.01)*

(86) International application number:
**PCT/JP2015/055703**

(87) International publication number:
**WO 2015/133371 (11.09.2015 Gazette 2015/36)**

(54) **ORGANIC THIN FILM TRANSISTOR**

ORGANISCHER DÜNNSCHICHTTRANSISTOR

TRANSISTOR À FILM MINCE ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.03.2014 JP 2014045169**

(43) Date of publication of application:
**11.01.2017 Bulletin 2017/02**

(73) Proprietor: **Fujifilm Corporation**
**Minato-ku**
**Tokyo 106-8620 (JP)**

(72) Inventor: **NIORI, Teruki**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**WO-A1-2012/165403**
**JP-A- 2004 335 932**
**JP-A- 2006 261 339**
**JP-A- 2012 253 132**
**US-A1- 2006 208 266**

EP 3 116 018 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND OF THE INVENTION**

1. Field of the Invention

The present invention relates to an organic thin-film transistor.

2. Description of the Related Art

Most of display devices such as a liquid crystal display, an organic EL display, and an electrophoretic display have a thin-film transistor (hereinafter, also referred to as a "TFT") incorporated therein as a display switching device. A TFT has a structure, on a substrate, formed of a gate electrode, a semiconductor layer, and a gate insulating layer provided between the gate electrode and the semiconductor layer, and a source electrode and a drain electrode are further provided in contact with the semiconductor layer. The TFT is driven by applying a voltage to the gate electrode. By applying a voltage to the gate electrode, the amount of carriers formed of electrons or holes in a semiconductor is controlled so that the current flowing between the source electrode and the drain electrode is controlled.
In the related art, an inorganic semiconductor such as amorphous or polycrystalline thin-film silicon has been used for a semiconductor used for a TFT. However, in a case where a semiconductor layer of a TFT is formed of an inorganic semiconductor, a vacuum process or a high-temperature process carried out at 300°C or higher is required and thus improvement of productivity is restricted.
In contrast, a TFT using an organic semiconductor has become popular in recent years. Since an organic semiconductor layer can be formed using a method such as an ink-jet method, a spin coating method, or a flexographic printing method, the film-forming process can be efficiently performed at a low temperature, a high speed, and low cost.
In an organic semiconductor layer, carrier mobility can be increased and a switching operation can be performed at a higher speed by improving the alignment of an organic semiconductor constituting the organic semiconductor layer. For example, JP2006-261339A describes that an organic semiconductor is aligned along the alignment direction of an underlayer, at the time of manufacturing a top-gate type organic thin-film transistor, by forming an underlayer that includes an organic polymer material having a liquid crystalline core and is aligned on a substrate in a predetermined direction and forming an organic semiconductor layer on the underlayer.
Further, JP2005-72200A describes a field-effect type organic transistor in which at least one layer of gate insulating layers has dielectric anisotropy and which is formed of a liquid crystal polymer. With the configuration of the transistor described in JP2005-72200A, alignment of an organic semiconductor formed on a gate insulating layer is controlled.

**SUMMARY OF THE INVENTION**

An object of the present invention is to provide a top-gate type organic thin-film transistor having excellent carrier mobility, in which an organic semiconductor layer is provided on an alignment layer comprising a liquid crystalline compound.
The above-described objects are achieved by the following means.

[1] A top gate type organic thin-film transistor comprising: a substrate; an alignment layer provided on the substrate; an organic semiconductor layer provided on the alignment layer; a gate insulating layer provided on the organic semiconductor layer; a gate electrode provided on the gate insulating layer; and a source electrode and a drain electrode provided in contact with the organic semiconductor layer and connected to each other through the organic semiconductor layer, in which the alignment layer comprises aligned discotic liquid crystalline compound and wherein the organic semiconductor layer contains a condensed polycyclic aromatic compound having a molecular weight of 300 to 2000.
[2] The organic thin-film transistor according to [1], in which the discotic liquid crystalline compound is a polymerizable discotic liquid crystalline compound, and the alignment layer contains by polymerized and immobilized discotic liquid crystalline compound.
[3] The organic thin-film transistor according to [1] or [2], in which the discotic liquid crystalline compound forms a discotic nematic phase in the alignment layer.
[4] The organic thin-film transistor according to any one of [1] to [3], in which the discotic liquid crystalline compound is horizontally aligned on the surface of the alignment layer on the organic semiconductor layer side.
[5] The organic thin-film transistor according to any one of [1] to [3], in which the discotic liquid crystalline compound is vertically aligned on the surface of the alignment layer on the organic semiconductor layer side.

[6] The organic thin-film transistor according to any one of [1] to [3], in which the discotic liquid crystalline compound is obliquely aligned on the surface of the alignment layer on the organic semiconductor layer side.

In the present specification, when a plurality of substituents or linking groups (hereinafter, referred to as substituents or the like) shown by specific symbols are present or a plurality of substituents are defined simultaneously or alternatively, this means that the respective substituents may be the same as or different from each other. The same applies to the regulation of the number of substituents or the like. Moreover, in a case where there is a repetition of a plurality of partial structures which are displayed in the same manner in the formula, the respective partial structures or repeating units may be the same as or different from each other. In addition, even in a case where not specifically stated, when a plurality of substituents or the like are adjacent (particularly, neighboring) to each other, they may be condensed or linked to each other and form a ring.

In regard to compounds (including polymers) described in the present specification, the description includes salts thereof and ions thereof in addition to the compounds. Further, the description includes partially changed structures within the range in which desired effects are exhibited.

In the present specification, substituents (the same applies to linking groups) in which substitution or non-substitution is not specified may further include substituents within the range not damaging desired effects of the present invention. The same applies to compounds in which substitution or non-substitution is not specified.

In addition, the numerical ranges shown using "to" in the present specification indicate ranges including the numerical values shown before and after "to" as the lower limits and the upper limits.

The organic thin-film transistor of the present invention is a top-gate type organic thin-film transistor having an organic semiconductor layer provided on an alignment layer comprising a liquid crystalline compound and exhibits excellent carrier mobility.

The above-described and other features and advantages of the present invention will become apparent from the description below with reference to the accompanying drawings.

## BRIEF DESCRIPTION OF THE DRAWINGS

Figs. 1A and 1B are views schematically illustrating an organic thin-film transistor according to preferred embodiments of the present invention.

## DESCRIPTION OF THE PREFERRED EMBODIMENTS

Hereinafter, the present invention will be described in detail.

[Organic thin-film transistor]

Embodiments of an organic thin-film transistor of the present invention (hereinafter, also simply referred to as an "OTFT of the present invention) will be described in detail below.

The OTFT of the present invention is a top-gate type transistor and includes a substrate; an alignment layer provided on the substrate; an organic semiconductor layer provided on the alignment layer; a gate insulating layer provided on the organic semiconductor layer; a gate electrode provided on the gate insulating layer; and a source electrode and a drain electrode provided in contact with the organic semiconductor layer and connected to each other through the organic semiconductor layer. When a voltage is applied to the gate electrode, a channel of a current is formed on the interface between a semiconductor layer and adjacent layer, positioned between the source electrode and the drain electrode. That is, the current flowing between the source electrode and the drain electrode is controlled according to the input voltage applied to the gate electrode.

Preferred embodiments of the OTFT according to the present invention will be described with reference to the accompanying drawings. The drawings illustrating respective OTFT are schematic views for facilitating understanding the present invention, and the size or the relative magnitude relation of each member is occasionally changed for the sake of convenience. Each member is not illustrated in actual scale. Moreover, the present invention is not limited to the outer shapes or shapes illustrated in the drawings except definitions described in the present invention.

Figs. 1A and 1B are respectively longitudinal sectional views schematically illustrating the OTFT according to preferred representative embodiments of the present invention. In Figs. 1A and 1B, the reference numeral 1 indicates an organic semiconductor layer, the reference numeral 2 indicates a gate insulating layer, the reference numeral 3 indicates a source electrode, the reference numeral 4 indicates a drain electrode, the reference numeral 5 indicates a gate electrode, the reference numeral 6 indicates a substrate, and the reference numeral 7 indicates an alignment layer.

Further, Fig. 1A illustrates a top-gate bottom-contact type OTFT and Fig. 1B illustrates a top-gate top-contact type OTFT. The OTFT of the present invention has the above-described two types. Although not illustrated, an overcoat

layer is formed on the uppermost portion (on the opposite side to a substrate 6) of the surface of each OTFT in some cases.
Members and materials constituting the OTFT of the present invention will be described below.

[Substrate]

A substrate which is capable of supporting the OTFT and a display panel or the like prepared on the OTFT can be used. The substrate is not particularly limited as long as the substrate has a sheet shape and the surface thereof is insulating and flat.
An inorganic material may be used as the material of the substrate. Examples of the substrate formed of an inorganic material include various glass substrates such as soda-lime glass and quartz glass, various glass substrates having an insulating film formed on the surface thereof, a quartz substrate having an insulating film formed on the surface thereof, a silicon substrate having an insulating film formed on the surface thereof, a sapphire substrate, metal substrates made of various alloys or various metals such as stainless steel, aluminum, and nickel, metal foil, and paper.
In a case where the substrate is formed of a semiconductive material or a conductive material such as a stainless sheet, aluminum foil, copper foil, or a silicon wafer, the surface thereof is typically coated with or overlapped with an insulating polymer material or a metal oxide for use.
Moreover, an organic material may also be used as the material of the substrate. Examples thereof include a plastic substrate (also referred to as a plastic film or a plastic sheet) which has flexibility and is formed of an organic polymer such as polymethylmethacrylate (PMMA), polyvinyl alcohol (PVA), polyvinyl phenyl (PVP), polyether sulfone (PES), polyimide, polyamide, polyacetal, polycarbonate (PC), polyethylene terephthalate (PET), polyethylene naphthalene (PEN), polyethyl ether ketone, polyolefin, or polycycloolefin. Further, a material formed from mica can be also exemplified.
When such a plastic substrate or the like having flexibility is used, incorporation or integration of the OTFT into/with a display device or an electronic device having a curved shape becomes possible.
Since an organic material forming the substrate is unlikely to be softened at the time of lamination on another layer or being heated, it is preferable that the glass transition point thereof is high, for example, 40°C or higher. Moreover, in terms that dimensional change resulting from a heat treatment at the time of production is unlikely to occur and stability of transistor performance is excellent, it is preferable that the linear expansion coefficient is small. For example, a material having a linear expansion coefficient of $25\times10^{-5}$ cm/cm·°C or less is preferable and a material having a linear expansion coefficient of $10\times10^{-5}$ cm/cm·°C or less is more preferable.
Further, as the organic material constituting the substrate, a material having resistance to a solvent used when the OTFT is produced is preferable and a material having excellent adhesion to a gate insulating layer and an electrode is preferable.
Moreover, it is preferable to use a plastic substrate formed of an organic polymer having excellent gas barrier properties.
It is also preferable that a dense silicon oxide film or the like is provided on at least one surface of the substrate or an inorganic material is deposited or laminated on at least one surface of the substrate.
Other examples of the substrate include conductive substrates (for example, a substrate formed of a metal such gold or aluminum, a substrate formed of highly oriented graphite, or stainless steel substrate).
A buffer layer used to improve the adhesion or flatness, a functional film such as a barrier film used to improve gas barrier properties, or a surface treatment layer such as an easily adhesive layer may be formed on the surface of the substrate or the substrate may be subjected to a surface treatment such as a corona treatment, a plasma treatment, or UV/ozone treatment.
The thickness of the substrate is preferably 10 mm or less, more preferably 2 mm or less, and particularly preferably 1 mm or less. Further, the thickness thereof is preferably 0.01 mm or greater and more preferably 0.05 mm or greater. Particularly, in a case of a plastic substrate, the thickness thereof is preferably in a range of 0.05 mm to 0.1 mm. Moreover, in a case of a substrate formed of an inorganic material, the thickness thereof is preferably in a range of 0.1 mm to 10 mm.

- Alignment treatment of substrate -

In the OTFT of the present invention, the surface of the substrate on the alignment layer side is subjected to an alignment treatment. The alignment treatment method is not particularly limited, and a known alignment treatment method of the related art can be employed. For example, the alignment treatment can be carried out using a rubbing treatment of an organic compound (preferably a polymer) constituting the substrate, oblique vapor deposition of an inorganic compound, formation of a layer having microgrooves, or accumulation of an organic compound (for example, ω-tricosanoic acid or methyl stearate) according to the Langmuir-Blodgett method (LB film). Further, the alignment treatment can be also carried out by applying an electric field or a magnetic field to the organic compound constituting

the surface of the substrate or irradiating the organic compound constituting the surface of the substrate with light (linearly polarized irradiation or non-polarized irradiation).

Among the above-described examples, in the present invention, it is preferable to employ a method of constituting at least the surface of the substrate on the alignment layer side with a polymer and rubbing the surface of the substrate on the alignment layer side. The rubbing treatment can be usually performed by rubbing the surface of the polymer layer with paper or cloth several times in a predetermined direction. Particularly, in the present invention, it is preferable that the rubbing treatment is carried out using a method described in "Handbook of Liquid Crystal" (publishing office: MARUZEN Co., Ltd., published on October 30, 2000, pp. 226 to 229).

When the surface of the substrate on the alignment layer side is subjected to an alignment treatment, a discotic liquid crystalline compound which becomes the material of the alignment layer described below can be aligned in accordance with the alignment treatment.

[Alignment layer]

An alignment layer is a layer formed by one or two or more discotic liquid crystalline compounds being aligned. As the discotic liquid crystalline compound, a known discotic liquid crystalline compound of the related art can be used. The discotic liquid crystalline compound is described in various literatures (C. Destrade et al., Mol. Crysr. Liq. Cryst., vol. 71, page 111 (1981); edited by the Chemical Society of Japan, reviewed by Quarterly Chemical, No. 22, liquid crystal chemistry, chapter 5, section 2 of chapter 10 (1994); B. Kohne et al., Angew. Chem. Soc. Chem. Comm., page 1794 (1985); J. Zhang et al., J. Am. Chem. Soc., vol. 116, page 2655 (1994)).

It is preferable that a liquid crystal phase of a discotic liquid crystalline compound forming an alignment layer is a discotic nematic phase. Further, on the surface of the alignment layer on the organic semiconductor side, it is preferable that the molecular alignment of the discotic liquid crystalline compound is any one of the vertical alignment, horizontal alignment, and oblique alignment.

In the alignment layer, the alignment direction of the polymerized and immobilized liquid crystalline compound may or may not be uniform in a space between the surface on the substrate side to the surface on the organic semiconductor layer side. Typically, the alignment direction of the discotic liquid crystalline compound is uniform in a space between the surface of the alignment layer on the substrate side to the surface on the organic semiconductor side.

In the present specification, a discotic liquid crystalline compound being "vertically aligned" means that the discotic liquid crystalline compound is aligned at an average inclination angle of 80° to 90° with respect to the surface of the alignment layer on the organic semiconductor layer side. The same applies to a case where the discotic liquid crystalline compound is polymerized and immobilized as described below.

In addition, in the present specification, a discotic liquid crystalline compound being "horizontally aligned" means that the discotic liquid crystalline compound is aligned at an average inclination angle of 0° to 10° with respect to the surface of the alignment layer on the organic semiconductor layer side. The same applies to a case where the discotic liquid crystalline compound is polymerized and immobilized as described below.

In addition, in the present specification, a discotic liquid crystalline compound being "obliquely aligned" means that the discotic liquid crystalline compound is aligned at an average inclination angle of greater than 10° to less than 80° with respect to the surface of the alignment layer on the organic semiconductor layer side. The same applies to a case where the discotic liquid crystalline compound is polymerized and immobilized as described below.

The "average inclination angle" in the present specification indicates an average angle between the disc surface of the discotic liquid crystalline molecule and the surface of the alignment layer on the organic semiconductor layer side. The minimum value of the average inclination angle is 0° and the maximum value thereof is 90°. The above-described "average angle" can be calculated by fitting incident angle dependence from two directions of the slow axis and the fast axis of retardation using ellipsometry.

The alignment layer is preferably formed by polymerizing and immobilizing one kind or two or more kinds of polymerizable (i.e., having a polymerizable group) discotic liquid crystalline compounds that are present in an aligned state. The polymerization of the discotic liquid crystalline compound is described in, for example, JP1996-27284A (JP-H8-27284A).

In the present specification, the expression "the polymerizable discotic liquid crystalline compound is polymerized and immobilized in the aligned state" means that the polymerizable discotic liquid crystalline compound is in a state in which the alignment thereof is stably held due to the polymerization reaction. When the discotic liquid crystalline compound is polymerized and immobilized in the aligned state, the polymerized and immobilized discotic liquid crystalline compound does not exhibit fluidity typically in a temperature range of 0°C to 100°C and the immobilized aligned state can be stably maintained even when an external field or an external force is applied thereto. In addition, when the polymerizable liquid crystalline compound is polymerized and immobilized in the aligned state, the polymerizable liquid crystalline compound no longer exhibits liquid crystallinity.

- Polymerizable discotic liquid crystalline compound -

A polymerizable discotic liquid crystalline compound is a discotic liquid crystalline compound having a polymerizable group. The polymerizable group is not particularly limited. For example, a cyclic ether group such as an ethylenically unsaturated group (that is, the ethylenically unsaturated group indicates a group having an ethylene bond (carbon-carbon double bond) consumed in measurement of the bromine value or the iodine value, and does not indicate an unsaturated group exhibiting aromaticity such as benzene), an epoxy group, or an oxetane group can be widely employed as a polymerizable group. It is preferable that an ethylenically unsaturated group is introduced as an acryloyl group, a methacryloyl group, an acrylamide group, a vinyl group, or a styryl group. The number of polymerizable groups included in a polymerizable liquid crystalline compound is not particularly limited. For example, a discotic liquid crystalline compound having 1 to 6 polymerizable groups in one molecule can be used. The number of polymerizable groups in one molecule of a polymerizable discotic liquid crystalline compound is preferably in a range of 1 to 5 and more preferably in a range of 1 to 3.

As the polymerizable discotic liquid crystalline compound, a compound in a form in which a polymerizable group is introduced to a known discotic liquid crystalline compound of the related art can be used. Specific examples of the discotic liquid crystalline compound having a polymerizable group, which can be preferably used in the present invention, include compounds in which X represents a group having a polymerizable group among compounds (1,3,5-substituted benzene type discotic liquid crystalline compound) described in paragraphs [0038] to [0069] of JP2009-97002A. Further, compounds having a polymerizable group as a substituent among compounds described in paragraphs [0062] to [0067] of JP2007-108732A can be preferably used in the present invention as the discotic liquid crystalline compound having a polymerizable group.

On the surface on which the alignment layer is formed or on a side on which at least the organic semiconductor layer is formed, it is preferable that the molecular alignment direction of the polymerizable discotic liquid crystalline compound is any one of the vertical alignment, horizontal alignment, and oblique alignment and the aligned state is immobilized due to a polymerization reaction (that is, on the surface of the alignment layer of the OTFT on the organic semiconductor side, it is preferable that the alignment direction of the polymerized and immobilized discotic liquid crystalline compound is the vertical alignment, horizontal alignment, or oblique alignment). In the alignment layer, the alignment direction of the polymerized and immobilized discotic liquid crystalline compound may or may not be uniform in a space between the surface on the substrate side to the surface on the organic semiconductor layer side. Typically, the alignment direction of the polymerized and immobilized discotic liquid crystalline compound is uniform in a space from the surface on the substrate side to the surface on the organic semiconductor layer side.

In a case of the polymerizable discotic liquid crystalline compound, it is preferable that a liquid crystal phase of the polymerizable liquid crystalline compound on the substrate becomes a discotic nematic phase during when a liquid crystal layer is formed and the alignment state thereof is immobilized due to the polymerization reaction.

The molecular weight of the polymerizable discotic liquid crystalline compound used in the present invention is preferably in a range of 400 to 3,000 and more preferably in a range of 600 to 2,000.

The alignment layer may be formed of only one layer or may be a laminate of two or more layers.

The alignment layer may contain components derived from materials forming the alignment layer, for example, an air interface alignment control agent, a cissing inhibitor, a polymerization initiator, and a polymerizable monomer, in addition to a discotic liquid crystalline compound and a polymer thereof.

The alignment layer can be formed by preparing a coating solution in which various materials (the above-described discotic liquid crystalline compound (including a polymerizable discotic liquid crystalline compound), an air interface alignment control agent, a cissing inhibitor, a polymerization initiator, and a polymerizable monomer) for forming the alignment layer are dissolved or dispersed in a solvent, coating the surface of the substrate subjected to the alignment treatment with the coating solution, heating the surface so that the discotic liquid crystalline compound is aligned in accordance with the alignment treatment subjected to the surface of the substrate, and polymerizing and immobilizing the aligned polymerizable liquid crystalline compound at the same time with the alignment or after the alignment in a case where a polymerizable discotic liquid crystalline compound is used. The components other than the liquid crystalline compound, which can form the above-described coating solution, are described below.

- Air interface alignment control agent -

The discotic liquid crystalline compound or the polymerizable discotic liquid crystalline compound can be more efficiently obliquely aligned, vertically aligned, or horizontally aligned on the surface of the alignment layer on the organic semiconductor layer side by selecting a combination of an additive unevenly distributed on the air interface (surface on a side on which the organic semiconductor layer is formed) and a discotic liquid crystalline compound or the polymerizable discotic liquid crystalline compound constituting the alignment layer.

A known air interface alignment control agent of the related art can be used as the air interface alignment

control agent. Among examples thereof, a compound having one or more substituted or unsubstituted aliphatic groups having 6 to 40 carbon atoms or substituted or unsubstituted aliphatic-substituted oligosiloxanoxy groups having 6 to 40 carbon atoms in a molecule is preferable and a compound having two or more substituted or unsubstituted aliphatic groups having 6 to 40 carbon atoms or substituted or unsubstituted aliphatic-substituted oligosiloxanoxy groups having 6 to 40 carbon atoms in a molecule is more preferable. The air interface alignment control agent which can be used in the present invention is described in, for example, JP1999-352328A (JP-H11-352328A) or JP2002-20363A. Further, a surfactant can be used as the air interface alignment control agent. Examples of the surfactant include known surfactants of the related art. Among known surfactants, a fluorine-based compound is particularly preferable. Specifically, compounds described in paragraphs [0028] to [0056] of JP2001-330725A and compounds described in paragraphs [0100] to [0118] of JP2005-179636A may be exemplified.

The content of the air interface alignment control agent in the coating solution is not particularly limited, but is preferably in a range of 0.2 parts by mass to 10 parts by mass, more preferably in a range of 0.2 parts by mass to 5 parts by mass, and still more preferably in a range of 0.2 parts by mass to 3 parts by mass with respect to 100 parts by mass of the polymerizable liquid crystalline compound.

- Cissing inhibitor -

A cissing inhibitor is a material for preventing cissing at the time of application of the coating solution. A compound used as a cissing inhibitor is not particularly limited unless the compound significantly inhibits a change in the inclination angle or alignment of the liquid crystalline composition of the present invention, and both of a polymer compound and a low molecular weight compound may be used. It is preferable that the cissing inhibitor is a polymer.

Examples of the polymer used as a cissing inhibitor are described in JP1996-95030A (JP-H8-95030A). Particularly preferred examples of the polymer used as a cissing inhibitor include cellulose ester. Examples of the cellulose ester include cellulose acetate, cellulose acetate propionate, hydroxy propyl cellulose, and cellulose acetate butyrate.

From the viewpoint that alignment of the discotic liquid crystalline compound or the polymerizable liquid crystalline compound is not inhibited, the concentration of the polymer, used to prevent cissing, in the coating solution is preferably in a range of 0.1% by mass to 10% by mass, more preferably in a range of 0.1% by mass to 8% by mass, and still more preferably in a range of 0.1% by mass to 5% by mass.

Moreover, a surfactant can be used as a cissing inhibitor. Examples of the surfactant include known surfactants of the related art. Among known surfactants, a fluorine-based compound is particularly preferable. Specifically, compounds described in paragraphs [0028] to [0056] of JP2001-330725A and compounds described in paragraphs [0100] to [0118] of JP2005-179636A may be exemplified. The cissing inhibitor can serve as an air interface alignment control agent. The concentration of the surfactant in the coating solution is preferably in a range of 0.005% by mass to 8% by mass and more preferably in a range of 0.05% by mass to 2.5% by mass.

- Polymerization initiator -

In a case where the alignment layer is polymerized and immobilized using the polymerizable discotic liquid crystalline compound, a polymerization initiator is preferably used. A polymerization initiator can be suitably selected in consideration of the target polymerization reaction, and, for example, a photopolymerization initiator or a thermal polymerization initiator can be used. As these polymerization initiators, known compounds of the related art can be used. Since it is preferable to employ a photopolymerization reaction as the polymerization reaction, as described below, for the purpose of preventing deformation or deterioration of a substrate or the like due to heat, a photopolymerization initiator is preferably used as the polymerization initiator to be used. Examples of the photopolymerization initiator include a radical polymerization initiator and a photo-cationic polymerization initiator. A radical polymerization initiator is preferably used in a case where the polymerizable group included in a discotic liquid crystalline compound is an ethylenically unsaturated group. Further, a photo-cationic polymerization initiator (preferably the above-described photoacid generator) is preferably used in a case where the polymerizable group included in a discotic liquid crystalline compound is an epoxy group, an oxetane group, or a methylol group. In the present invention, a radical polymerization initiator is more preferable.

Examples of the photopolymerization initiator include an $\alpha$-carbonyl compound (such as an $\alpha$-carbonyl compound described in each specification of US2367661A and US2367670A), acyloin ether (such as acryloin ether described in the specification of US2448828A), an $\alpha$-hydrocarbon-substituted aromatic acyloin compound (such as an $\alpha$-hydrocarbon-substituted aromatic acyloin compound described in the specification of US2722512A), a polynuclear quinone compound (such as a polynuclear quinone compound described in each specification of US3046127A and US2951758A), a combination of a triaryl imidazole dimer and p-aminophenyl ketone (such as a combination of a triaryl imidazole dimer and p-aminophenyl ketone described in the specification of US3549367A), an acridine and phenazine compound (such as an acridine and phenazine compound described in JP1985-105667A (JP-S60-105667A) and US4239850A), and an

oxadiazole compound (an oxadiazole compound described in the specification of US4212970A).

The use amount of the photopolymerization initiator in the coating solution is preferably in a range of 0.01% by mass to 20% by mass and more preferably in a range of 0.5% by mass to 5% by mass with respect to the solid content in the coating solution.

- Polymerizable monomer -

The above-described coating solution used to form the alignment layer may contain a polymerizable monomer. The polymerizable monomer is not particularly limited as long as the polymerizable monomer has compatibility with the discotic liquid crystalline compound and alignment of the discotic liquid crystalline compound is not significantly inhibited. In order to more effectively immobilize the alignment state of the discotic liquid crystalline compound, a compound having an ethylenically unsaturated group exhibiting polymerization activity such as a vinyl group, a vinyloxy group, an acryloyl group, or a methacryloyl group is preferably used. The content of the polymerizable monomer in the coating solution is preferably in a range of 0.5% by mass to 50% by mass and more preferably in a range of 1% by mass to 30% by mass with respect to 100% by mass of the discotic liquid crystalline compound in the coating solution. Moreover, since an effect of improving solvent resistance can be expected, it is particularly preferable that a monomer having two or more polymerizable groups is used. The number of polymerizable groups included in one molecule of a polymerizable monomer is preferably in a range of 2 to 6 and more preferably in a range of 2 to 4.

The molecular weight of the polymerizable monomer is preferably in a range of 100 to 600 and more preferably in a range of 150 to 400.

- Coating solvent -

As a solvent used for the coating solution that is used to form the alignment layer, an organic solvent is preferably used. Examples of the organic solvent include an amide (such as N,N-dimethylformamide), a sulfoxide (such as dimethyl sulfoxide), a heterocyclic compound (such as pyridine), a hydrocarbon (such as toluene or hexane), an alkyl halide (such as chloroform or dichloromethane), an ester (such as methyl acetate or butyl acetate), a ketone (such as acetone, methyl ethyl ketone, methyl isobutyl ketone, or cyclohexanone), and an ether (such as tetrahydrofuran or 1,2-dimethoxyethane). Among these, an alkyl halide, an ester, and a ketone are preferable. For the coating solution, a combination of two or more organic solvents may be used.

- Coating method -

The alignment layer is formed by firstly preparing a coating solution for forming the alignment layer, coating the substrate whose surface is subjected to the alignment treatment with this coating solution, and aligning the discotic liquid crystalline compound. The surface is coated with the coating solution according to a known method (such as a spin coating method, a wire bar coating method, an extrusion coating method, a direct gravure coating method, a reverse gravure coating method, or a die coating method).

- Alignment of discotic liquid crystalline compound -

The discotic liquid crystalline compound can be aligned by coating the surface with the coating solution and then heating the surface to a liquid crystal temperature range. The liquid crystal temperature range is preferably 50°C to 200°C and more preferably 70°C to 150°C. In a case where the liquid crystal temperature range is high, the temperature can be adjusted using the amount of various materials to be added.

[Polymerization method]

In a case where a polymerizable discotic liquid crystalline compound is used as a discotic liquid crystalline compound, after the polymerizable discotic liquid crystalline compound is aligned in accordance with the alignment treatment applied to the surface of the substrate, the polymerizable discotic liquid crystalline compound (a polymerizable discotic liquid crystalline compound and a polymerizable monomer in a case where the coating solution contains a polymerizable monomer in addition to a polymerizable discotic liquid crystalline compound in order to form an alignment layer) can be polymerized to immobilize the alignment state. Examples of the polymerization reaction include a thermal polymerization reaction using a thermal polymerization initiator, a photopolymerization reaction using a photopolymerization initiator, and a polymerization reaction generated by performing irradiation with electron beams. Among these, in order to prevent deformation or deterioration of a support or the like caused by heat, a photopolymerization reaction or a polymerization reaction generated by performing irradiation with electron beams is preferable and a photopolymerization reaction is more preferable. As the photopolymerization reaction, a radical polymerization reaction or a cationic polymerization reaction is preferable and a radical polymerization reaction is more preferable.

It is preferable to use ultraviolet rays for irradiation with light for the purpose of polymerization. The irradiation energy (integration) is preferably in a range of 10 $mJ/cm^2$ to 50 $J/cm^2$ and more preferably in a range of 50 $mJ/cm^2$ to 800 $mJ/cm^2$. In order to accelerate the photopolymerization reaction, irradiation with light may be carried out under the condition of heating. Further, since the oxygen concentration in the atmosphere affects the degree of polymerization, in a case where the degree of polymerization does not reach a desired degree of polymerization in air, it is preferable that the oxygen concentration is lowered according to a method of nitrogen concentration or the like. The concentration of oxygen in the atmosphere in which the polymerization reaction occurs is preferably 10% or less, more preferably 7% or less, and most preferably 3% or less. The temperature of the photopolymerization reaction is preferably in a range of 40°C to 150°C and more preferably in a range of 60°C to 100°C.

[Gate electrode]

A known electrode of the related art being used as a gate electrode of an OTFT can be used as the gate electrode. A conductive material (also referred to as an electrode material) constituting the gate electrode is not particularly limited. Examples thereof include metals such as platinum, gold, silver, aluminum, chromium, nickel, copper, molybdenum, titanium, magnesium, calcium, barium, sodium, palladium, iron, and manganese; conductive metal oxides such as $InO_2$, $SnO_2$, indium tin oxide (ITO), fluorine-doped tin oxide (FTO), aluminum-doped zinc oxide (AZO), and gallium-doped zinc oxide (GZO); conductive polymers such as polyaniline, polypyrrole, polythiophene, polyacetylene, and poly(3,4-ethylenedioxythiophene)/polystyrene sulfonic acid (PEDOT/PSS); and conductive composite materials obtained by dispersing the above-described conductive polymer to which a dopant, for example, an acid such as hydrochloric acid, sulfuric acid, or sulfonic acid, Lewis acid such as $PF_6$, $AsF_5$, or $FeCl_3$, a halogen atom such as iodine, or a metal atom such as sodium or potassium is added, carbon black, graphite powder, or metal fine particles therein. These materials may be used alone or in combination of optional two or more kinds thereof at an optional ratio.

In addition, the gate electrode may be configured of a single layer or two or more layers being laminated, formed of the above-described conductive materials.

A method of forming the gate electrode is not limited. Examples thereof include a method of patterning a film, formed using a physical vapor deposition (PVD) method such as a vacuum vapor deposition method, a chemical vapor deposition method (CVD method), a sputtering method, a printing method (coating method), a transfer method, a sol-gel method, or a plating method, in a desired shape as needed.

According to the coating method, a film is formed or an electrode is directly formed by preparing, applying, drying, baking, photocuring, or aging a solution, paste, or a dispersion liquid of the above-described material.

Moreover, from the viewpoints of capability of desired patterning, simplifying the processes, cost reduction, and speeding up, it is preferable to use ink jet printing, screen printing, (inversion) offset printing, relief printing, intaglio printing, planographic printing, thermal transfer printing, or a microcontact printing method.

In a case where a spin coating method, a die coating method, a micro gravure coating method, or a dip coating method is employed, patterning can be carried out by combining any of these method and the following photolithographic method.

As the photolithographic method, a method of combining patterning of a photoresist, etching, for example, wet etching using an etching solution or dry etching using a reactive plasma, and a lift-off method may be exemplified.

As another patterning method, a method of irradiating the above-described materials with energy rays such as laser or electron beams and polishing the materials so that the conductivity of the material is changed may be exemplified.

In addition, a method of transferring a composition for a gate electrode which is printed on a support other than a substrate may be exemplified.

The thickness of the gate electrode is optional, but is preferably 1 nm or greater and particularly preferably 10 nm or greater. Further, the thickness thereof is preferably 500 nm or less and particularly preferably 200 nm or less.

[Gate insulating layer]

The gate insulating layer is not particularly limited as long as the layer has insulating properties and the gate insulating layer may be formed of a single layer or multiple layers.

It is preferable that the gate insulating layer is formed of an insulating material, and preferred examples of the insulating material include an organic polymer and an inorganic oxide.

The organic polymer and the inorganic oxide are not particularly limited as long as the organic polymer and the inorganic oxide have insulating properties, and it is preferable that the organic polymer and the inorganic oxide are formed of a thin film having a thickness of 1 μm or less.

The organic polymer and the inorganic oxide may be used alone or in combination of two or more kinds thereof

and the organic polymer may be combined with the inorganic oxide.

The organic polymer is not particularly limited, and examples thereof include polyvinyl phenol, polystyrene (PS), poly(meth)acrylate represented by polymethyl methacrylate, polyvinyl alcohol, polyvinyl chloride (PVC), polyvinylidene fluoride (PVDF), polytetrafluoroethylene (PTFE), a cyclic fluoroalkyl polymer represented by CYTOP, polycycloolefin, polyester, polyether sulfone, polyether ketone, polyimide, an epoxy resin, polyorganosiloxane represented by polydimethylsiloxane (PDMS), polysilsesquioxane, and butadiene rubber. Further, other examples thereof include thermosetting resins such as a phenolic resin, a novolak resin, a cinnamate resin, an acrylic resin, and a polyparaxylylene resin.

The organic polymer can be combined with a compound including a reactive substituent such as an alkoxysilyl group, a vinyl group, an acryloyloxy group, an epoxy group, or a methylol group.

In a case where the gate insulating layer is formed using an organic polymer, it is also preferable that the organic polymer is cross-linked and cured for the purpose of increasing the solvent resistance or insulation resistance of the gate insulating layer. It is preferable that the crosslinking is performed by generating an acid or a radical using light or heat or both of these.

In a case where the crosslinking is performed by generating a radical, as a radical generator that generates a radical using light or heat, for example, a thermal polymerization initiator (H1) and a photopolymerization initiator (H2) described in the paragraphs [0182] to [0186] of JP2013-214649A, a photo-radical generator described in the paragraphs [0046] to [0051] of JP2011-186069A, and a photo-radical polymerization initiator described in the paragraphs [0042] to [0056] of JP2010-285518A can be preferably used. Moreover, it is preferable that "a compound (G) which has a number average molecular weight (Mn) of 140 to 5,000, includes a crosslinkable functional group, and does not include a fluorine atom" described in the paragraphs [0167] to [0177] of JP2013-214649A is preferably used.

In a case where the crosslinking is performed by generating an acid, as a photoacid generator that generates an acid using light, for example, a photocationic polymerization initiator described in the paragraphs [0033] and [0034] of JP2010-285518A, and an acid generator, particularly sulfonium salts and iodonium salts described in the paragraphs [0120] to [0136] of JP2012-163946A can be preferably used. As a thermal acid generator (catalyst) that generates an acid using heat, for example, a thermal cationic polymerization initiator and particularly onium salts described in the paragraphs [0035] to [0038] of JP2010-285518A, and a catalyst and particularly sulfonic acids and sulfonic acid amine salts described in the paragraphs [0034] and [0035] of JP2005-354012A can be preferably used. Moreover, a crosslinking agent and particularly a difunctional or higher functional epoxy compound and an oxetane compound described in the paragraphs [0032] and [0033] of JP2005-354012A, a crosslinking agent and particularly a compound which includes two or more crosslinking group and in which at least one of the crosslinking groups is a methylol group or an NH group described in the paragraphs [0046] to [0062] of JP2006-303465A, and a hydroxymethyl group or a compound having two or more alkoxymethyl groups in a molecule described in the paragraphs [0137] to [0145] of JP2012-163946A are preferably used.

As a method of forming the gate insulating layer with an organic polymer, a method of applying and curing an organic polymer may be exemplified. The coating method is not particularly limited, and the above-described various printing methods are exemplified. Among those, a wet coating method such as a micro gravure coating method, a dip coating method, screen coating printing, a die coating method, or a spin coating method is preferable.

The inorganic oxide is not particularly limited, and examples thereof include oxides such as silicon oxide, silicon nitride ($SiN_Y$), hafnium oxide, titanium oxide, tantalum oxide, aluminum oxide, niobium oxide, zirconium oxide, copper oxide, and nickel oxide; perovskites such as $SrTiO_3$, $CaTiO_3$, $BaTiO_3$, $MgTiO_3$, and $SrNb_2O_6$; and a composite oxide or a mixture of these. Here, as the silicon oxide, in addition to silicon oxide ($SiO_x$), BPSG, PSG, BSG, AsSG, PbSG, silicon oxynitride (SiON), spin on glass (SOG), and $SiO_2$-based materials having a low dielectric constant (for example, polyaryl ether, a cycloperfluorocarbon polymer, benzocyclobutene, a cyclic fluorine resin, polytetrafluoroethylene, fluorinated aryl ether, fluorinated polyimide, amorphous carbon, and organic SOG) are included.

As a method forming the gate insulating layer with an inorganic oxide, a vacuum film formation method such as a vacuum vapor deposition method, a sputtering method, ion plating, or a CVD method can be used, and assist may be performed using a plasma, an ion gun, or a radical gun using optional gas during the film formation.

Moreover, the gate insulating layer may be formed by reacting a precursor corresponding to each metal oxide, specifically, a metal halide or a metal alkoxide such as a chloride or a bromide, or a metal hydroxide with an acid such as hydrochloric acid, sulfuric acid, or nitric acid, or a base such as sodium hydroxide or potassium hydroxide in alcohol or water for hydrolysis. In a case of using such a solution-based process, the above-described wet coating method can be used.

The gate insulating layer can be also provided using a method obtained by combining any of a lift-off method, a sol-gel method, an electrodeposition method, and a shadow mask method with a patterning method, if necessary, other than the above-described methods.

The gate insulating layer may be subjected to a surface treatment such as a corona treatment, a plasma treatment, or a UV/ozone treatment. In this case, it is preferable not to make the surface rough due to the surface treatment. An arithmetic mean roughness Ra or a root mean square roughness $R_{MS}$ of the surface of the gate insulating

layer is preferably 0.5 nm or less.

[Organic semiconductor layer]

An organic semiconductor layer is a layer which exhibits properties of a semiconductor and on which carriers can be accumulated.

The organic semiconductor layer contains an organic semiconductor.

The organic semiconductor is a low molecular weight compound.

In the present invention, the low molecular weight compound indicates a compound other than an organic polymer and a derivative thereof, that is, a compound that does not have a repeating unit. The molecular weight of the low molecular weight compound is in a range of 300 to 2000 and preferably in a range of 400 to 1000.

As the low molecular weight compound, a condensed polycyclic aromatic compound is used. Examples thereof include acene such as naphthacene, pentacene(2,3,6,7-dibenzoanthracene), hexacene, heptacene, dibenzopentacene, or tetrabenzopentacene, anthradithiophene, pyrene, benzopyrene, dibenzopyrene, chrysene, perylene, coronene, terrylene, ovalene, quaterrylene, circumanthracene, a derivative in which some of these carbon atoms are substituted with atoms such as N, S, and O, a derivative (a dioxa anthanthrene-based compound including perixanthenoxanthene and a derivative thereof, triphenodioxazine, triphenodithiazine, or hexacene-6,15-quinone) in which at least one hydrogen atom bonded to the carbon atom is substituted with a functional group such as a carbonyl group, and a derivative in which the hydrogen atom is substituted with another functional group.

Further, other examples thereof include metal phthalocyanine represented by copper phthalocyanine, tetrathiapentalene and a derivative thereof, naphthalene tetracarboxylic acid diimide such as naphthalene-1,4,5,8-tetracarboxylic acid diimide, N,N'-bis(4-trifluoromethylbenzyl)naphthalene-1,4,5,8-tetracarboxylic acid diimide, N,N'-bis(1H,1H-perfluorooctyl), N,N'-bis(1H,1H-perfluorobutyl), a N,N'-dioctylnaphthalene-1,4,5,8-tetracarboxylic acid diimide derivative, or naphthalene-2,3,6,7-tetracarboxylic acid diimide, condensed ring tetracarboxylic acid diimide, for example, anthracene tetracarboxylic acid diimide such as anthracene-2,3,6,7-tetracarboxylic acid diimide, fullerene such as C60, C70, C76, C78, or C84 and a derivative of these, a carbon nanotube such as SWNT, and dyes such as a merocyanine dye and a hemicyanine dye and a derivative of these.

Moreover, polyanthracene, triphenylene, and quinacridone are also exemplified.

The condensed polycyclic aromatic compound is highly effective in improving carrier mobility and durability and exhibits an excellent effect of decreasing the threshold voltage.

As the condensed polycyclic aromatic compound, acene represented by any of Formulae (A1) to (A4) and a compound represented by any of the following Formulae (C) to (T) are preferable, and a compound represented by any of the following Formulae (C) to (T) is more preferable from the viewpoint that the compound is easily unevenly distributed together with the resin (C).

The acene which is preferable as the condensed polycyclic aromatic compound is represented by the following Formula (A1) or (A2).

Formula (A1)

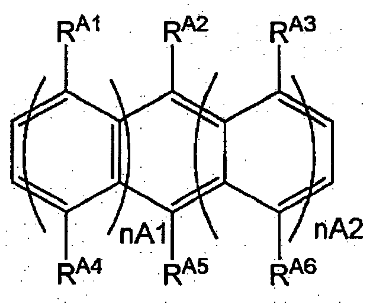

Formula (A2)

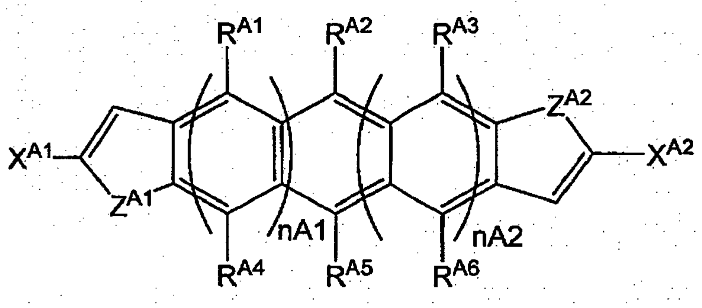

In Formulae, $R^{A1}$ to $R^{A6}$ and $X^{A1}$ and $X^{A2}$ represent a hydrogen atom or a substituent.

$Z^{A1}$ and $Z^{A2}$ represent S, O, Se, or Te.

nA1 and nA2 represent an integer of 0 to 3. In this case, nA1 and nA2 do not represent 0 at the same time.

The substituent respectively represented by $R^{A1}$ to $R^{A6}$ and $X^{A1}$ and $X^{A2}$ is not particularly limited, and examples thereof include an alkyl group (such as methyl, ethyl, propyl, isopropyl, tert-butyl, pentyl, tert-pentyl, hexyl, octyl, tert-octyl, dodecyl, tridecyl, tetradecyl, or pentadecyl), a cycloalkyl group (such as cyclopentyl or cyclohexyl), an alkenyl group (such as vinyl, allyl, 1-propenyl, 2-butenyl, 1,3-butadienyl, 2-pentenyl, or isopropenyl), an alkynyl group (such as

ethynyl or propargyl), an aromatic hydrocarbon group (also referred to as an aromatic carbocyclic group or an aryl group, and examples thereof include phenyl, p-chlorophenyl, mesityl, tolyl, xylyl, naphthyl, anthryl, azulenyl, acenaphthenyl, fluorenyl, phenanthryl, indenyl, pyrenyl, and biphenylyl), an aromatic heterocyclic group (also referred to as a heteroaryl group, and examples thereof include a pyridyl group, a pyrimidinyl group, a furyl group, a pyrrolyl group, an imidazolyl group, a benzoimidazolyl group, a pyrazolyl group, a pyrazinyl group, a triazolyl group (such as a 1,2,4-triazol-1-yl group or a 1,2,3-triazol-1-yl group), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (a group in which one carbon atom constituting a carboline ring of a carbolinyl group is replaced with a nitrogen atom), a quinoxalinyl group, a pyridazinyl group, a triazinyl group, a triazinyl group, a quinazolinyl group, and a phthalazinyl group), a heterocyclic group (also referred to as a heteroaryl ring group, and examples thereof include a pyrrolidyl group, an imidazolidyl group, a morpholyl group, and an oxazolidyl group), an alkoxy group (such as methoxy, ethoxy, propyloxy, pentyloxy, hexyloxy, octyloxy, or dodecyloxy), a cycloalkoxy group (such as cyclopentyloxy or cyclohexyloxy), an aryloxy group (such as phenoxy or naphthyloxy), an alkylthio group (such as methylthio, ethylthio, propylthio, pentylthio,hexylthio, octylthio, or dodecylthio), a cycloalkylthio group (such as cyclopentylthio or cyclohexylthio), an arylthio group (such as phenylthio or naphthylthio), an alkoxycarbonyl group (such as methyloxycarbonyl, ethyloxycarbonyl, butyloxycarbonyl, octyloxycarbonyl, or dodecyloxycarbonyl), an aryloxycarbonyl group (such as phenyloxycarbonyl or naphthyloxycarbonyl), a sulfamoyl group (such as aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, or 2-pyridylaminosulfonyl), an acyl group (such as acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, or pyridylcarbonyl), an acyloxy group (such as acetyloxy, ethylcarbonyloxy, butylcarbonyloxy, octylcarbonyloxy, or dodecylcarbonyloxy, phenylcarbonyloxy), an amide group (such as methylcarbonylamino, ethylcarbonylamino, dimethylcarbonyl amino, propylcarbonylamino, pentylcarbonylamino, cyclohexylcarbonylamino, 2-ethylhexylcarbonylamino, octylcarbonylamino, dodecylcarbonylamino, phenylcarbonylamino, or naphthylcarbonylamino), a carbamoyl group (such as aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, naphthylaminocarbonyl, or 2-pyridylaminocarbonyl), an ureido group (such as methylureido, ethylureido, pentylureido, cyclohexylureido, octylureido, dodecylureido, phenylureido, naphthylureido, or 2-pyridylaminoureido), a sulfinyl group (such as methylsulfinyl, ethylsulfinyl, butylsulfinyl, cyclohexylsulfinyl, 2-ethylhexylsulfinyl, dodecylsulfinyl, phenylsulfinyl, naphthylsulfinyl, or 2-pyridylsulfinyl), an alkylsulfonyl group (such as methylsulfonyl, ethylsulfonyl, butylsulfonyl, cyclohexylsulfonyl, 2-ethylhexylsulfonyl, or dodecylsulfonyl), an arylsulfonyl group (such as phenylsulfonyl, naphthylsulfonyl, or 2-pyridylsulfonyl), an amino group (such as amino, ethylamino, dimethylamino, butylamino, cyclopentylamino, 2-ethylhexylamino, dodecylamino, anilino, naphthylamino, or 2-pyridylamino), a halogen atom (such as a fluorine atom, a chlorine atom, or a bromine atom), a fluorinated hydrocarbon group (such as fluoromethyl, trifluoromethyl, pentafluoroethyl, or pentafluorophenyl), a cyano group, a nitro group, a hydroxyl group, a mercapto group, a silyl group (such as trimethylsilyl, triisopropylsilyl, triphenylsilyl, or phenyldiethylsilyl), and a group (in this case, $X^A$ represents Ge or Sn) represented by the following Formula (SG1).

These substituents may further include a plurality of substituents. As the plurality of substituents which may be included in these substituents, substituents represented by $R^{A1}$ to $R^{A6}$ are exemplified.

Among the above-described examples of acene, one represented by the following Formula (A3) or (A4) is preferable.

Formula (A3)

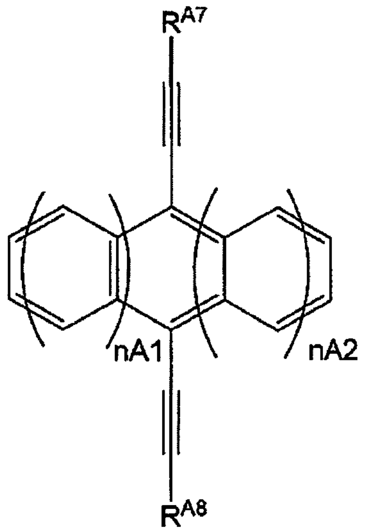

Formula (A4)

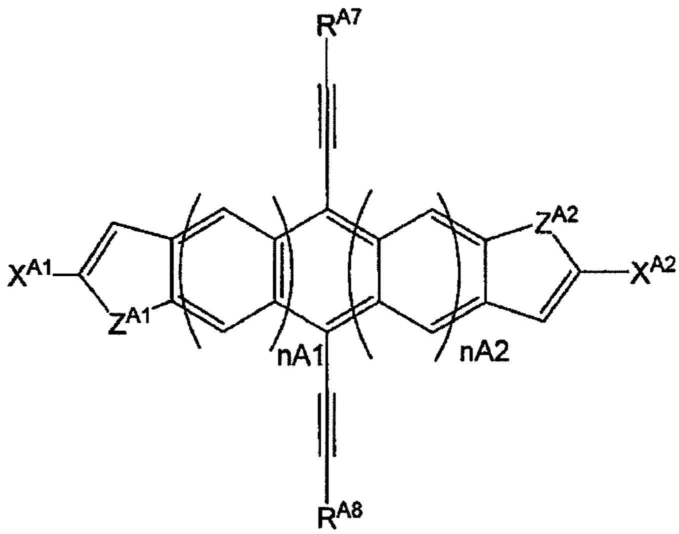

In the formulae, $R^{A7}$, $R^{A8}$, $X^{A1}$, and $X^{A2}$ represent a hydrogen atom or a substituent. $R^{A7}$, $R^{A8}$, $X^{A1}$ , and $X^{A2}$ may be the same as or different from each other. Preferred examples of the substituents represented by $R^{A7}$ and $R^{A8}$ include those exemplified as the substituents which may be employed as $R^{A1}$ to $R^{A6}$ in Formulae (A1) and (A2).

$Z^{A1}$ and $Z^{A2}$ represent S, O, Se, or Te.

nA1 and nA2 represent an integer of 0 to 3. In this case, nA1 and nA2 do not represent 0 at the same time.

In Formula (A3) or (A4), it is preferable that $R^{A7}$ and $R^{A8}$ are represented by the following Formula (SG1).

Formula (SG1)

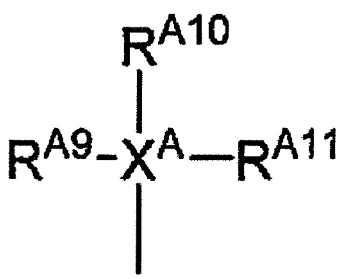

In the formula, $R^{A9}$ to $R^{A11}$ represent a substituent. $X^A$ represents Si, Ge, or Sn. Preferred examples of the substituents represented by $R^{A9}$ and $R^{A11}$ include those exemplified as the substituents which may be employed as $R^{A1}$ to $R^{A6}$ in Formulae (A1) and (A2).

Hereinafter, specific examples of acene or an acene derivative represented by Formula (A1) to (A4) will be described, but the present invention is not limited to those.

Compound A1

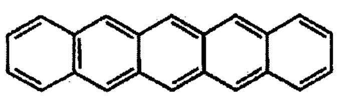

Compound A2

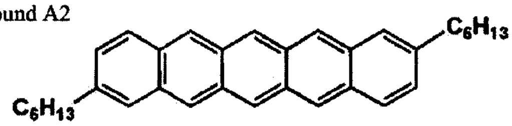

Compound A3

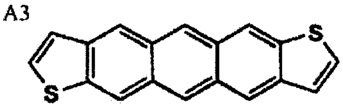

Compound A4

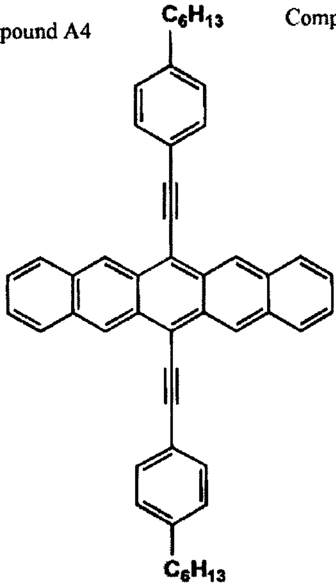

Compound A5

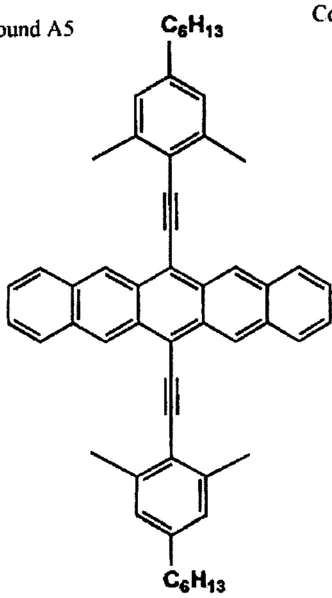

Compound A6

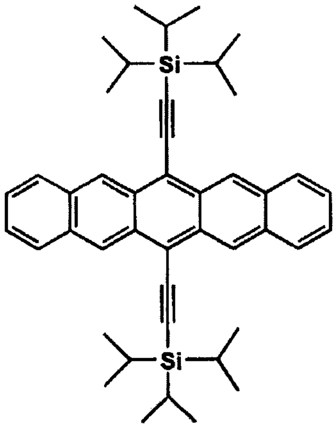

Compound A7

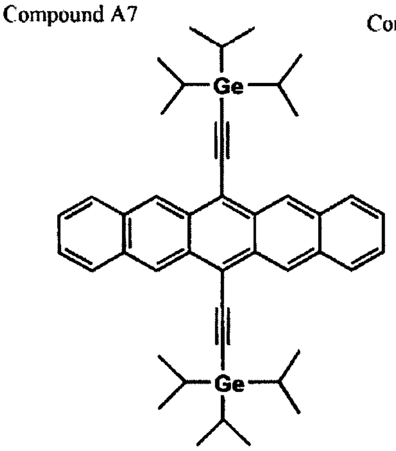

Compound A8

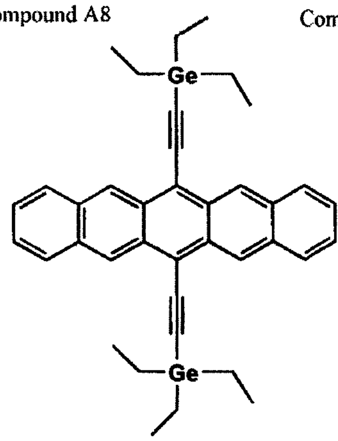

Compound A9

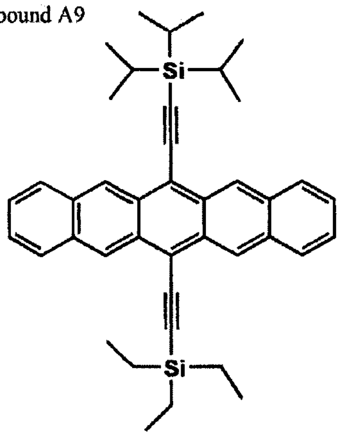

Compound A10

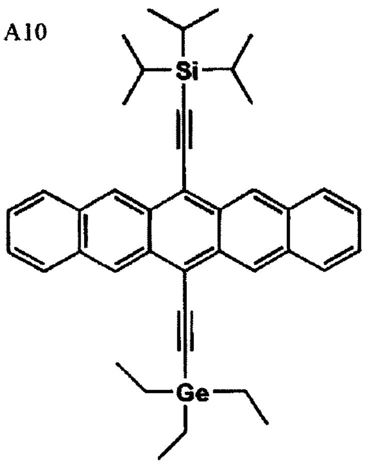

Compound A11

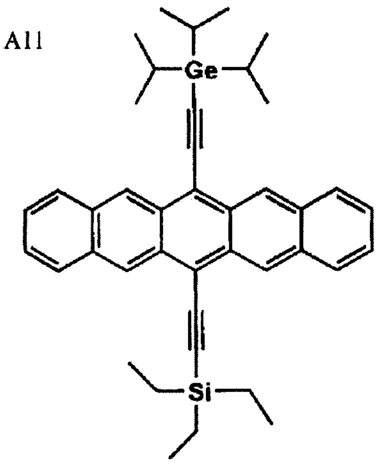

Compound A12

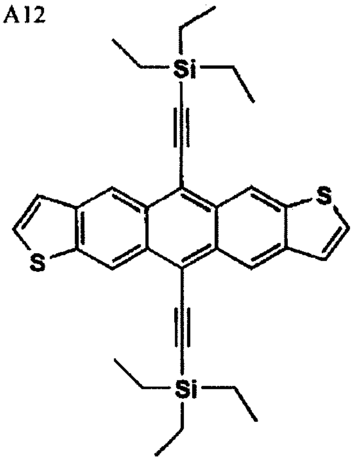

Compound A13

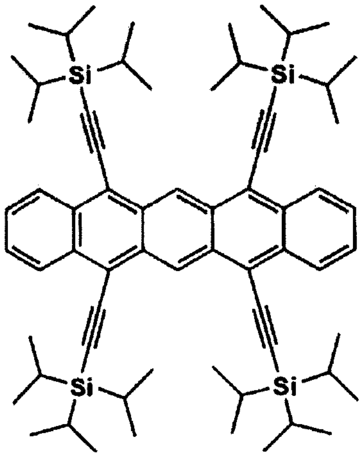

Compound A14

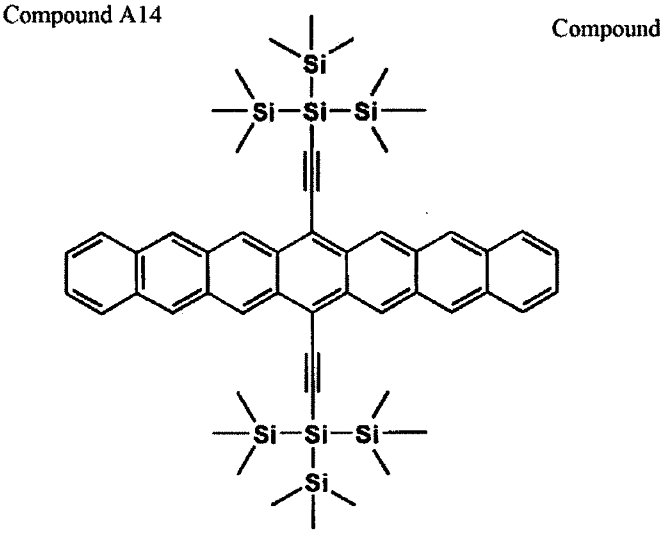

Compound A15

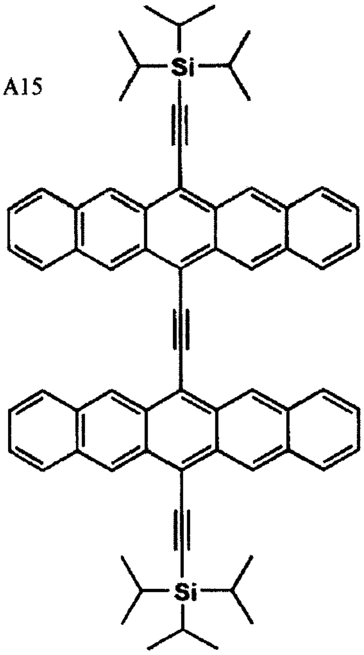

Compound A16

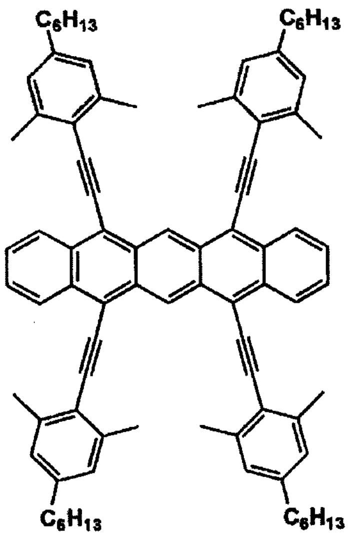

Compound A17

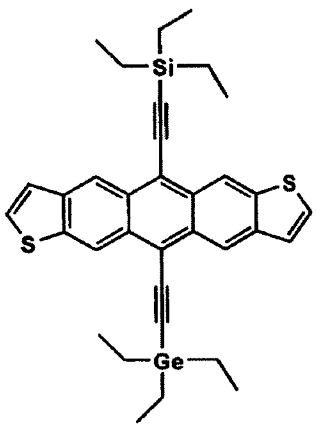

Compound A18

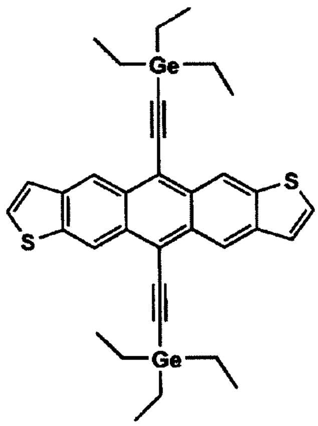

Compound A19

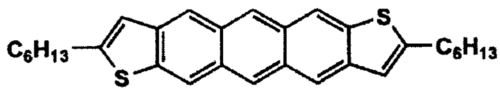

Compound A20

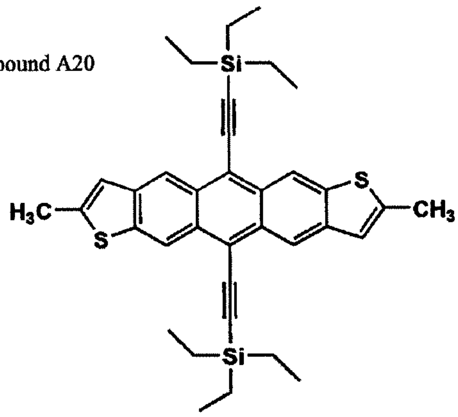

Compound A21

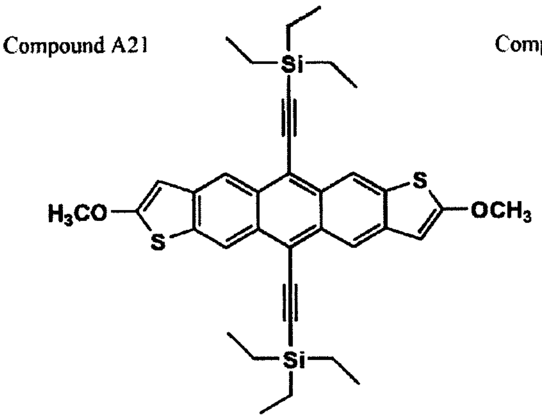

Compound A22

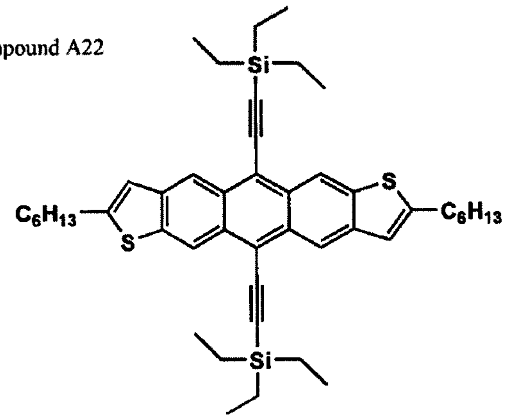

Compound A23

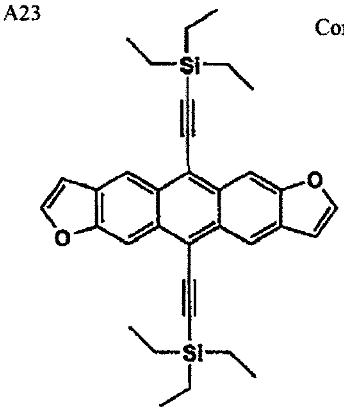

Compound A24

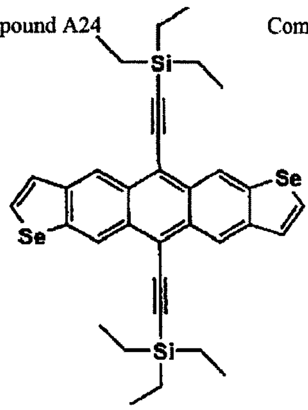

Compound A25

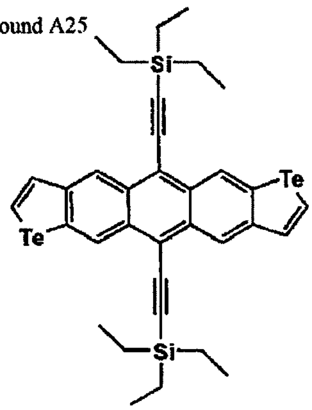

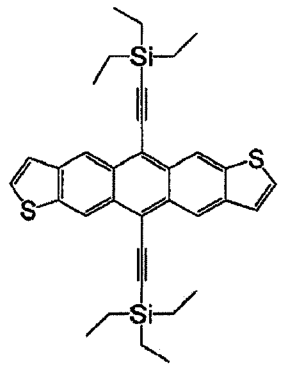

Compound A26

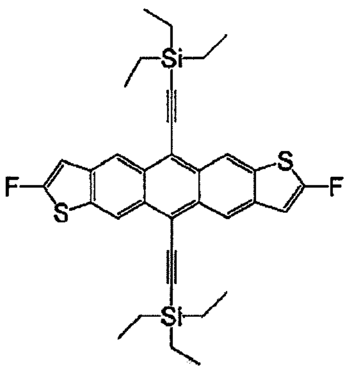

Compound A27

As the condensed polycyclic aromatic compound, compounds represented by the following Formulae (C) to (T) are also preferable.

Formula (C)

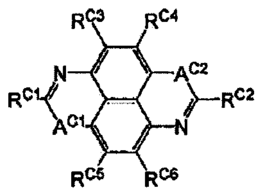

Formula (D)

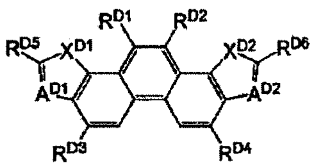

Formula (E)

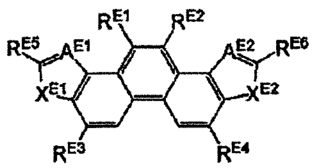

Formula (F)

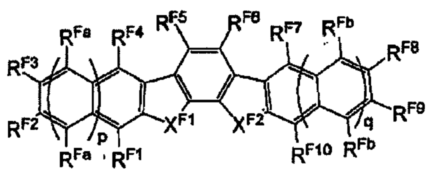

Formula (G)

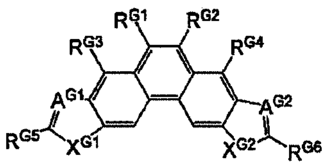

Formula (H)

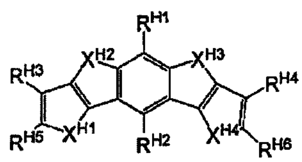

Formula (J)

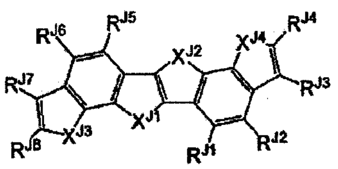

Formula (K)

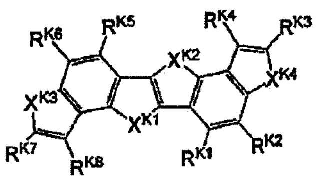

Formula (L)

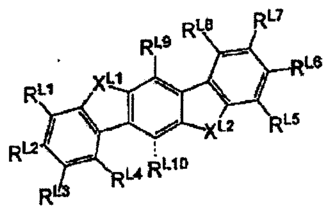

Formula (M)

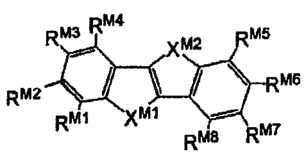

Formula (N)

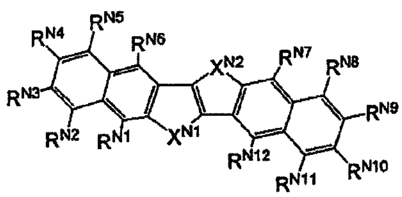

Formula (P)

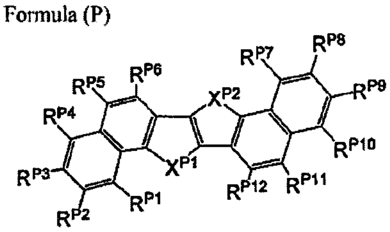

Formula (Q)

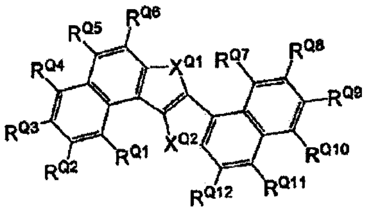

Formula (R)

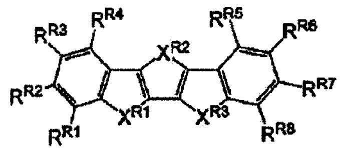

Formula (S)

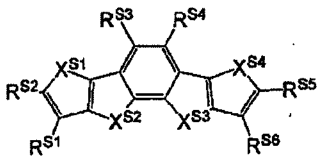

Formula (T)

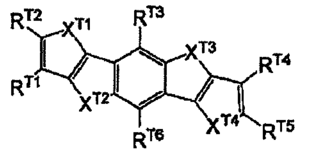

In Formula (C), $A^{C1}$ and $A^{C2}$ represent an oxygen atom, a sulfur atom, or a selenium atom. It is preferable that both of $A^{C1}$ and $A^{C2}$ represent an oxygen atom or a sulfur atom and more preferable that $A^{C1}$ and $A^{C2}$ represent a sulfur atom. $R^{C1}$ to $R^{C6}$ represent a hydrogen atom or a substituent. At least one of $R^{C1}$, ..., or $R^{C6}$ represents a substituent represented by the following Formula (W).

In Formula (D), $X^{D1}$ and $X^{D2}$ represent $NR^{D9}$, an oxygen atom, or a sulfur atom. $A^{D1}$ represents $CR^{D7}$ or a N atom, $A^{D2}$ represents $CR^{D8}$ or a N atom, $R^{D9}$ represents a hydrogen atom, an alkyl group, an alkenyl group, an alkynyl group, or an acyl group. $R^{D1}$ to $R^{D8}$ represent a hydrogen atom or a substituent, and at least one of $R^{D1}$, ..., or $R^{D8}$ represents a substituent represented by the following Formula (W).

In Formula (E), $X^{E1}$ and $X^{E2}$ represent an oxygen atom, a sulfur atom, or $NR^{E7}$. $A^{E1}$ and $A^{E2}$ represent $CR^{E8}$ or a nitrogen atom. $R^{E1}$ to $R^{E8}$ represent a hydrogen atom or a substituent. At least one of $R^{E1}$, ..., or $R^{E8}$ represents a substituent represented by the following Formula (W).

In Formula (F), $X^{F1}$ and $X^{F2}$ represent an oxygen atom, a sulfur atom, or a selenium atom. It is preferable that $X^{F1}$ and $X^{F2}$ represent an oxygen atom or a sulfur atom and more preferable that $X^{F1}$ and $X^{F2}$ represent a sulfur atom. $R^{F1}$ to $R^{F10}$, $R^{Fa}$, and $R^{Fb}$ represent a hydrogen atom or a substituent. At least one of $R^{F1}$ to $R^{F10}$, $R^{Fa}$, or $R^{Fb}$ represents a substituent represented by Formula (W). p and q represent an integer of 0 to 2.

In Formula (G), $X^{G1}$ and $X^{G2}$ represent $NR^{G9}$, an oxygen atom, or a sulfur atom. $A^{G1}$ represents $CR^{G7}$ or a N atom. $A^{G2}$ represents $CR^{G8}$ or a N atom. $R^{G9}$ represents a hydrogen atom, an alkyl group, an alkenyl group, an alkynyl group, an acyl group, an aryl group, or a heteroaryl group. $R^{G1}$ to $R^{G8}$ represent a hydrogen atom or a substituent. At least one of $R^{G1}$, ..., or $R^{G8}$ represents a substituent represented by the following Formula (W).

In Formula (H), $X^{H1}$ and $X^{H4}$ represent $NR^{H7}$, an oxygen atom, or a sulfur atom. It is preferable that $X^{H1}$ to $X^{H4}$ represent a sulfur atom. $R^{H7}$ represents a hydrogen atom, an alkyl group, an alkenyl group, an alkynyl group, an acyl group, an aryl group, or a heteroaryl group. $R^{H1}$ to $R^{H6}$ represent a hydrogen atom or a substituent. At least one of $R^{H1}$, ..., or $R^{H6}$ represents a substituent represented by the following Formula (W).

In Formula (J), $X^{J1}$ and $X^{J2}$ represent an oxygen atom, a sulfur atom, a selenium atom, or $NR^{J9}$. $X^{J3}$ and $X^{J4}$ represent an oxygen atom, a sulfur atom, or a selenium atom. It is preferable that $X^{J1}$, $X^{J2}$, $X^{J3}$, and $X^{J4}$ represent a sulfur atom. $R^{J1}$ to $R^{J9}$ represent a hydrogen atom or a substituent. At least one of $R^{J1}$, ..., or $R^{J9}$ represents a substituent represented by the following Formula (W).

In Formula (K), $X^{K1}$ and $X^{K2}$ represent an oxygen atom, a sulfur atom, a selenium atom, or $NR^{K9}$. $X^{K3}$ and $X^{K4}$ represent an oxygen atom, a sulfur atom, or a selenium atom. It is preferable that $X^{K1}$, $X^{K2}$, $X^{K3}$, and $X^{K4}$ represent a sulfur atom. $R^{K1}$ to $R^{K9}$ represent a hydrogen atom or a substituent. At least one of $R^{K1}$, ..., or $R^{K9}$ represents a substituent represented by the following Formula (W).

In Formula (L), $X^{L1}$ and $X^{L2}$ represent an oxygen atom, a sulfur atom, or $NR^{L11}$. It is preferable that $X^{L1}$ and $X^{L2}$ represent an oxygen atom or a sulfur atom. $R^{L1}$ to $R^{L11}$ represent a hydrogen atom or a substituent, and at least one of $R^{L1}$, ..., or $R^{L11}$ represents a substituent represented by the following Formula (W).

In Formula (M), $X^{M1}$ and $X^{M2}$ represent an oxygen atom, a sulfur atom, a selenium atom, or $NR^{M9}$. It is preferable that $X^{M1}$ and $X^{M2}$ represent a sulfur atom. $R^{M1}$ to $R^{M9}$ represent a hydrogen atom or a substituent. At least one of $R^{M1}$, ..., or $R^{M9}$ represents a substituent represented by the following Formula (W).

In Formula (N), $X^{N1}$ and $X^{N2}$ represent an oxygen atom, a sulfur atom, a selenium atom, or $NR^{N13}$. It is preferable that $X^{N1}$ and $X^{N2}$ represent a sulfur atom. $R^{N1}$ to $R^{N13}$ represent a hydrogen atom or a substituent. At least one of $R^{N1}$, ..., or $R^{N13}$ represents a substituent represented by the following Formula (W).

In Formula (P), $X^{P1}$ and $X^{P2}$ represent an oxygen atom, a sulfur atom, a selenium atom, or $NR^{P13}$. It is preferable

that $X^{P1}$ and $X^{P2}$ represent a sulfur atom. $R^{P1}$ to $R^{P13}$ represent a hydrogen atom or a substituent. At least one of $R^{P1}$, ..., or $R^{P13}$ represents a substituent represented by the following Formula (W).

In Formula (Q), $X^{Q1}$ and $X^{Q2}$ represent an oxygen atom, a sulfur atom, a selenium atom, or $NR^{Q13}$. It is preferable that $X^{Q1}$ and $X^{Q2}$ represent a sulfur atom. $R^{Q1}$ to $R^{Q13}$ represent a hydrogen atom or a substituent. At least one of $R^{Q1}$, ..., or $R^{Q13}$ represents a substituent represented by the following Formula (W).

In Formula (R), $X^{R1}$, $X^{R2}$, and $X^{R3}$ represent an oxygen atom, a sulfur atom, a selenium atom, or $NR^{R9}$. It is preferable that $X^{R1}$, $X^{R2}$, and $X^{R3}$ represent a sulfur atom. $R^{R1}$ to $R^{R9}$ represent a hydrogen atom or a substituent. At least one of $R^{R1}$, ..., or $R^{R9}$ represents a substituent represented by the following Formula (W).

In Formula (S), $X^{S1}$, $X^{S2}$, $X^{S3}$, and $X^{S4}$ represent an oxygen atom, a sulfur atom, a selenium atom, or $NR^{S7}$. It is preferable that $X^{S1}$, $X^{S2}$, $X^{S3}$, and $X^{S4}$ represent a sulfur atom. $R^{S1}$ to $R^{S7}$ represent a hydrogen atom or a substituent. At least one of $R^{S1}$, ..., or $R^{S7}$ represents a substituent represented by the following Formula (W).

In Formula (T), $X^{T1}$, $X^{T2}$, $X^{T3}$, and $X^{T4}$ represent an oxygen atom, a sulfur atom, a selenium atom, or $NR^{T7}$. It is preferable that $X^{T1}$, $X^{T2}$, $X^{T3}$, and $X^{T4}$ represent a sulfur atom. $R^{T1}$ to $R^{T7}$ represent a hydrogen atom or a substituent. At least one of $R^{T1}$, ..., or $R^{T7}$ represents a substituent represented by the following Formula (W).

Hereinafter, in Formulae (C) to (T), $R^{C1}$ to $R^{C6}$, $R^{D1}$ to $R^{D8}$, $R^{E1}$ to $R^{E8}$, $R^{F1}$ to $R^{F10}$, $R^{Fa}$ and $F^{Fb}$, $R^{G1}$ to $R^{G8}$, $R^{H1}$ to $R^{H6}$, $R^{J1}$ to $R^{J9}$, $R^{K1}$ to $R^{K9}$, $R^{L1}$ to $R^{L11}$, $R^{M1}$ to $R^{M9}$, $R^{N1}$ to $R^{N13}$, $R^{P1}$ to $R^{P13}$, $R^{Q1}$ to $R^{Q13}$, $R^{R1}$ to $R^{R9}$, $R^{S1}$ to $R^{S7}$, and $R^{T1}$ to $R^{T7}$ (hereinafter, referred to as substituents $R^C$ to $R^T$) which represent a hydrogen atom or a substituent.

Examples of the substituent which may be employed by the substituents $R^C$ to $R^T$ include a halogen atom, an alkyl group (an alkyl group having 1 to 40 carbon atoms such as methyl, ethyl, propyl, butyl, pentyl, hexyl, heptyl, octyl, nonyl, decyl, undecyl, dodecyl, tridecyl, tetradecyl, or pentadecyl, and in this case, 2,6-dimethyloctyl, 2-decyltetradecyl, 2-hexyldodecyl, 2-ethyloctyl, 2-decyltetradecyl, 2-butyldecyl, 1-octylnonyl, 2-ethyloctyl, 2-octyltetradecyl, 2-ethylhexyl, cycloalkyl, bicycloalkyl, and tricycloalkyl are included), an alkenyl group (such as 1-pentenyl, cycloalkenyl, or bicycloalkenyl), an alkynyl group (such as 1-pentynyl, trimethylsilylethynyl, triethylsilylethynyl, tri-i-propylsilylethynyl, or 2-p-propylphenylethynyl), an aryl group (for example, an aryl group having 6 to 20 carbon atoms such as phenyl, naphthyl, p-pentylphenyl, 3,4-dipentylphenyl, p-heptoxyphenyl, or 3,4-diheptoxyphenyl), a heterocyclic group (such as a 2-hexylfuranyl group), a cyano group, a hydroxy group, a nitro group, an acyl group (such as hexanoyl or benzoyl), an alkoxy group (such as buthoxy), an aryloxy group, a silyloxy group, a heterocyclic oxy group, an acyloxy group, a carbamoyloxy group, an amino group (such as an anilino group), an acylamino group, an aminocarbonylamino group (such as an ureido group), an alkoxy aryloxycarbonylamino group, an alkyl arylsulfonylamino group, a mercapto group, an alkyl arylthio group (such as methylthio or octylthio), a heterocyclic thio group, a sulfamoyl group, a sulfo group, an alkyl arylsulfinyl group, an alkyl arylsulfonyl group, an alkyl aryloxycarbonyl group, a carbamoyl group, an aryl heterocyclic azo group, an imido group, a phosphino group, a phosphinyl group, a phosphinyloxy group, a phosphinylamino group, a phosphono group, a silyl group (such as a ditrimethylsiloxymethylbutoxy group), a hydrazino group, an ureido group, a boronic acid group ($-B(OH)_2$), a phosphate group ($-OPO(OH)_2$), a sulfato group($-OSO_3H$), and other known substituents.

These substituents may further include the above-described substituents.

Among these, as the substituents which may be employed by the substituents $R^C$ to $R^T$, an alkyl group, an aryl group, an alkenyl group, an alkynyl group, a heterocyclic group, an alkoxy group, an alkylthio group, and a group represented by the following Formula (W) are preferable, an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, and a group represented by the following Formula (W) are more preferable, a group represented by the following Formula (W) is particularly preferable, and a group represented by the following Formula (W) is more particularly preferable.

The alkyl group, the alkenyl group, the alkynyl group, the acyl group, and the aryl group as $R^{D9}$, $R^{G9}$, and $R^{H7}$ described above respectively have the same definitions as those for the alkyl group, the alkenyl group, the alkynyl group, the acyl group, and the aryl group described in the section of the substituents which may be employed by the substituents $R^C$ to $R^T$.

Moreover, the heteroaryl group has the same definition as that for the heteroaryl group described in the section of the substituents of $R^{A1}$ to $R^{A6}$.

Formula (W) describes a group represented by $-L-R^W$.

In Formula (W), L represents a divalent linking group represented by any of the following Formulae (L-1) to (L-25) or a divalent linking group in which two or more (preferably 2 to 10, more preferably 2 to 6, and still more preferably 2 or 3) linking groups represented by any of Formulae (L-1) to (L25) are bonded to each other. $R^W$ represents a substituted or unsubstituted alkyl group, a cyano group, a vinyl group, an ethynyl group, an oxyethylene group, an oligooxyethylene group in which a repeating number v of oxyethylene units is 2 or greater, a siloxane group, an oligosiloxane group having 2 or more silicon atoms, or a substituted or unsubstituted trialkylsilyl group.

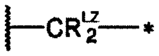
(L-1)

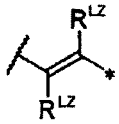
(L-2)

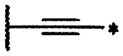
(L-3)

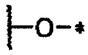
(L-4)

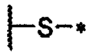
(L-5)

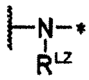
(L-6)

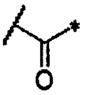
(L-7)

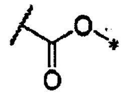
(L-8)

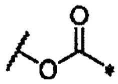
(L-9)

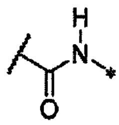
(L-10)

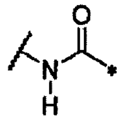
(L-11)

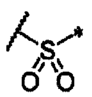
(L-12)

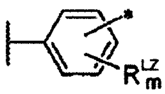
(L-13)

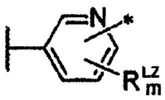
(L-14)

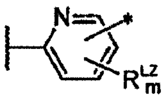
(L-15)

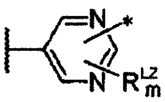
(L-16)

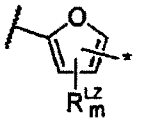
(L-17)

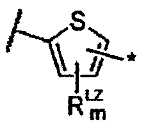
(L-18)

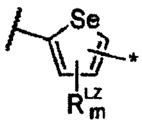
(L-19)

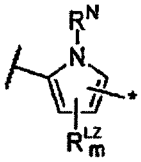
(L-20)

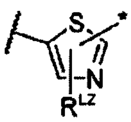
(L-21)

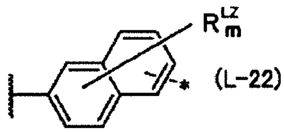
(L-22)

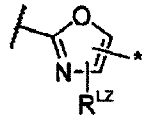
(L-23)

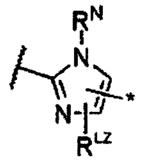
(L-24)

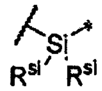
(L-25)

In Formulae (L-1) to (L-25), each wavy line represents a binding position with respect to a ring forming each skeleton represented by any of Formulae (C) to (T). Moreover, in the present specification, in a case where L represents a divalent linking group in which two or more divalent linking groups represented by any of Formulae (L-1) to (L25) are bonded to each other, each wavy line may represent a binding position with a ring forming each skeleton represented by any of Formulae (C) to (T) or a binding position with respect to any of the divalent linking groups represented by Formulae (L-1) to (L25).

The symbol "*" represents a binding position with respect to $R^W$ or a binding position with respect to a wavy line represented by any of Formula (L-1) to (L-25).

m in Formula (L-13) represents 4, m's in Formulae (L-14) and (L-15) represent 3, m's in Formulae (L-16) to (L-20) represent 2, and m in Formula (L-22) represents 6.

$R^{LZ'}{}_s$ in Formulae (L-1), (L-2), (L-6), (L-13) to (L-19), and (L-21) to (L-24) each independently represent a hydrogen atom or a substituent, and $R^{LZ'}$s in Formulae (L-1) and (L-2) may be respectively bonded to $R^W$ adjacent to L and form a condensed ring.

$R^N$'s represent a hydrogen atom or a substituent and $R^{si}$'s each independently represent a hydrogen atom, an

alkyl group, an alkenyl group, or an alkynyl group.

It is more preferable that the divalent linking groups represented by Formulae (L-17) to (L21), (L-23), and (L-24) are divalent linking groups represented by the following Formulae (L-17A) to (L-21A), (L-23A), and (L-24A).

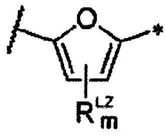

(L-17A)

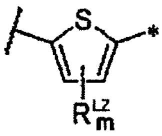

(L-18A)

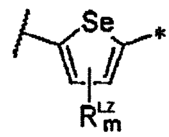

(L-19A)

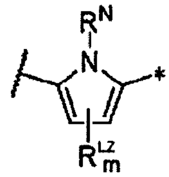

(L-20A)

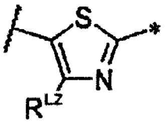

(L-21A)

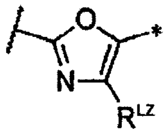

(L-23A)

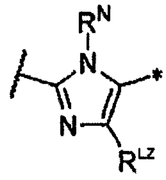

(L-24A)

Here, in a case where a substituted or unsubstituted alkyl group, an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent can be interpreted as $-R^W$ alone in Formula (W) or as $-L-R^W$ in Formula (W).

In the present invention, in a case where a substituted or unsubstituted alkyl group having N carbon atoms in the main chain is present at the terminal of a substituent, this substituent is determined to be interpreted not as $-R^W$ alone but as $-L-R^W$ in Formula (W), including as many linking groups as possible from the terminal of the substituent. Specifically, this substituent is interpreted as a substituent in which "one (L-1) corresponding to L in Formula (W)" is bonded to "a substituted or unsubstituted alkyl group having N-1 carbon atoms in the main chain corresponding to $R^W$ in Formula (W)." For example, in a case where an n-octyl group which is an alkyl group having 8 carbon atoms is present at the terminal of a substituent, this substituent is interpreted as a substituent in which one (L-1) having two $R^{LZ}$'s representing a hydrogen atom is bonded to an n-heptyl group having 7 carbon atoms. Further, in a case where a substituent represented by Formula (W) is an alkoxy group having 8 carbon atoms, this substituent is interpreted as a substituent in which one linking group represented by -O- of Formula (L-4), one linking group represented by (L-1) in which two $R^{LZ}$'s represent a hydrogen atom, and an n-heptyl group having 7 carbon atoms are bonded to each other.

Meanwhile, in the present invention, in a case where an oxyethylene group, an oligooxyethylene group in which the repeating number v of oxyethylene units is 2 or greater, a siloxane group, an oligosiloxane group having 2 or more silicon atoms, or a substituted or unsubstituted trialkylsilyl group is present at the terminal of a substituent, this substituent is interpreted as $R^W$ alone in Formula (W), including linking groups as many as possible from the terminal of the substituent. For example, in a case where a $-(OCH_2CH_2)-(OCH_2CH_2)-(OCH_2CH_2)-OCH_3$ group is present at the terminal of a substituent, this substituent is interpreted as an oligooxyethylene group alone in which the repeating number v of oxyethylene units is 3.

In a case where a linking group to which a divalent linking group in which L is represented by any of Formulae (L-1) to (L-25) is formed, the number of bonds of the divalent linking group represented by any of Formulae (L-1) to (L-25) is preferably in a range of 2 to 4 and more preferably 2 or 3.

Examples of the substituent $R^{LZ}$ in Formulae (L-1), (L-2), (L-6), and (L-13) to (L-24) include those exemplified as the substituents which may be employed by the substituents $R^C$ to $R^T$ of Formulae (C) to (T). Among these, it is preferable that the substituent RLZ in Formula (L-6) represents an alkyl group. In the case where $R^{LZ}$ in Formula (L-6) represents an alkyl group, the number of carbon atoms of the alkyl group is preferably in a range of 1 to 9, more preferably in a range of 4 to 9 from the viewpoints of chemical stability and carrier transportability, and still more preferably in a range of 5 to 9. In the case where $R^{LZ}$ in (L-6) is an alkyl group, it is preferable that the alkyl group is a linear alkyl group from the viewpoint of improving the carrier transportability.

Examples of $R^N$ include those exemplified as the substituents which may be employed by the substituents $R^C$ to $R^T$. Among these, it is preferable that $R^N$ represents a hydrogen atom or a methyl group.

It is preferable that $R^{si}$ represents an alkyl group. The alkyl group which may be employed by $R^{si}$ is not particularly limited, but the preferable range of the alkyl group which may be employed by $R^{si}$ is the same as the preferable range

of an alkyl group which may be employed by a silyl group in a case where $R^W$ represents a silyl group. The alkenyl group which may be employed as $R^{si}$ is not particularly limited, but a substituted or unsubstituted alkenyl group is preferable and a branched alkenyl group is more preferable as the alkenyl group. The number of carbon atoms of the alkenyl group is preferably 2 or 3. The alkynyl group which may be employed as $R^{si}$ is not particularly limited, but a substituted or unsubstituted alkynyl group is preferable and a branched alkynyl group is more preferable as the alkynyl group. The number of carbon atoms thereof is preferably 2 or 3.

It is preferable that L represents a divalent linking group represented by any of Formulae (L-1) to (L-5), (L-13), (L-17), and (L-18) or a divalent linking group in which two or more divalent linking groups represented by any of Formulae (L-1) to (L-5), (L-13), (L-17), and (L-18) are bonded to each other, more preferable that L represents a divalent linking group represented by any of Formulae (L-1), (L-3), (L-13), and (L-18) or a divalent linking group in which two or more divalent linking groups represented by any of Formulae (L-1), (L-3), (L-13), and (L-18) are bonded to each other, and particularly preferable that L represents a divalent linking group represented by any of Formulae (L-1), (L-3), (L-13), and (L-18) or a divalent linking group in which a divalent linking group represented by any one of Formulae (L-3), (L-13), and (L-18) is bonded to a divalent linking group represented by Formula (L-1). In the divalent linking group in which a divalent linking group represented by any one of Formulae (L-3), (L-13), and (L-18) is bonded to a divalent linking group represented by Formula (L-1), it is preferable that the divalent linking group represented by Formula (L-1) is bonded to the $R^W$ side.

From the viewpoints of chemical stability and carrier transportability, it is particularly preferable that L represents a divalent linking group which has a divalent linking group represented by Formula (L-1), more particularly preferable that L represents a divalent linking group represented by Formula (L-1), still more particularly preferable that L represents a divalent linking group represented by Formula (L-18) or (L-1), the divalent linking group is bonded to $R^W$ through (L-1), and $R^W$ represents a substituted or unsubstituted alkyl group, and even still more particularly preferable that L represents a divalent linking group represented by Formula (L-18A) or (L-1), the divalent linking group is bonded to $R^W$ through (L-1), and $R^W$ represents a substituted or unsubstituted alkyl group.

In Formula (W), it is preferable that $R^W$ represents a substituted or unsubstituted alkyl group. In Formula (W), in a case where L adjacent to $R^W$ represents a divalent linking group represented by Formula (L-1), it is preferable that $R^W$ represents a substituted or unsubstituted alkyl group, an oxyethylene group, an oligooxyethylene group in which the repeating number of oxyethylene units is 2 or greater, a siloxane group, or an oligosiloxane group having 2 or more silicon atoms and more preferable that $R^W$ represents a substituted or unsubstituted alkyl group.

In Formula (W), in a case where L adjacent to $R^W$ represents a divalent linking group represented by any of Formulae (L-2) and (L-4) to (L-25), it is more preferable that $R^W$ represents a substituted or unsubstituted alkyl group.

In Formula (W), in a case where L adjacent to $R^W$ represents a divalent linking group represented by Formula (L-3), it is preferable that $R^W$ represents a substituted or unsubstituted alkyl group or a substituted or unsubstituted silyl group.

In a case where $R^W$ represents a substituted or unsubstituted alkyl group, the number of carbon atoms is preferably in a range of 4 to 17, more preferably in a range of 6 to 14 from the viewpoints of chemical stability and carrier transportability, and still more preferably in a range of 6 to 12. From the viewpoints of improving linearity of a molecule and carrier transportability, it is preferable that $R^W$ represents a long-chain alkyl group, particularly a long-chain linear alkyl group, within the above-described range.

In a case where $R^W$ represents an alkyl group, the alkyl group may be linear, branched, or cyclic, but it is preferable that the alkyl group is linear from the viewpoints of improving the linearity of a molecule and the carrier transportability.

As a combination of $R^W$ and L of Formula (W), from the viewpoint of improving the carrier mobility, it is preferable that L in Formulae (C) to (T) represents a divalent linking group represented by Formula (L-1) and $R^W$ represents a linear alkyl group having 4 to 17 carbon atoms or L represents a divalent linking group in which a divalent linking group represented by any one of Formulae (L-3), (L-13), or (L-18) is bonded to a divalent linking group represented by Formula (L-1) and $R^W$ represents a linear alkyl group.

In the case where L represents a divalent linking group represented by Formula (L-1) and $R^W$ represents a linear alkyl group having 4 to 17 carbon atoms, it is more preferable that $R^W$ represents a linear alkyl group having 6 to 14 carbon atoms from the viewpoint of improving the carrier mobility and particularly preferable that $R^W$ represents a linear alkyl group having 6 to 12 carbon atoms.

In the case where L represents a divalent linking group in which a divalent linking group represented by any one of Formulae (L-3), (L-13), and (L-18) is bonded to a divalent linking group represented by Formula (L-1) and $R^W$ represents a linear alkyl group, it is more preferable that $R^W$ represents a linear alkyl group having 4 to 17 carbon atoms, more preferable that $R^W$ represents a linear alkyl group having 6 to 14 carbon atoms from the viewpoints of the chemical stability and carrier mobility, and particularly preferable that $R^W$ represents a linear alkyl group having 6 to 12 carbon atoms from the viewpoint of improving the carrier mobility.

Meanwhile, from the viewpoint of improving solubility in an organic solvent, it is preferable that $R^W$ represents

a branched alkyl group.

In a case where $R^W$ represents an alkyl group having a substituent, a halogen atom may be exemplified as the substituent and a fluorine atom is preferable. Moreover, in a case where $R^W$ represents an alkyl group having a fluorine atom, all hydrogen atom of the alkyl group may be substituted with fluorine atoms to form a perfluoroalkyl group. In this case, it is preferable that $R^W$ represents an unsubstituted alkyl group.

In a case where $R^W$ represents an ethyleneoxy group or an oligoethyleneoxy group, in the present specification, the "oligooxyethylene group" represented by $R^W$ indicates a group represented by $-(OCH_2CH_2)_vOY$ (the repeating number v of oxyethylene units is an integer of 2 or greater and Y at the terminal represents a hydrogen atom or a substituent). Further, in a case where Y at the terminal of the oligooxyethylene group represents a hydrogen atom, this becomes a hydroxy group. The repeating number v of the oxyethylene units is preferably in a range of 2 to 4 and more preferably 2 or 3. It is preferable that the hydroxy group at the terminal of the oligooxyethylene group is sealed, that is, Y represents a substituent. In this case, it is preferable that the hydroxy group is sealed by an alkyl group having 1 to 3 carbon atoms, that is, Y represents an alkyl group having 1 to 3 carbon atoms, more preferable that Y represents a methyl group or an ethyl group, and particularly preferable that Y represents a methyl group.

In a case where $R^W$ represents a siloxane group or an oligosiloxane group, the repeating number of siloxane units is preferably 2 to 4 and more preferably 2 or 3. Further, it is preferable that a hydrogen atom or an alkyl group is bonded to a Si atom. In a case where an alkyl group is bonded to a Si atom, the number of carbon atoms of the alkyl group is preferably in a range of 1 to 3, and it is preferable that a methyl group or an ethyl group is bonded to the Si atom. The same alkyl groups may be bonded to a Si atom or alkyl groups which are different from each other or hydrogen atoms may be bonded thereto. In addition, all siloxane units constituting an oligosiloxane group may be the same as or different from each other, but it is preferable that all siloxane units are the same as each other.

In a case where L adjacent to $R^W$ represents a divalent linking group represented by Formula (L-3), it is also preferable that $R^W$ represents a substituted or unsubstituted silyl group. In the case where $R^W$ represents a substituted or unsubstituted silyl group, it is preferable that $R^W$ represents a substituted silyl group. The substituted of the silyl group is not particularly limited, but a substituted or unsubstituted alkyl group is preferable and a branched alkyl group is more preferable as the substituent. In the case where $R^W$ represents a trialkylsilyl group, the number of carbon atoms of an alkyl group bonded to a Si atom is preferably in a range of 1 to 3, and it is preferable that a methyl group, an ethyl group, or an isopropyl group is bonded to a Si atom. Alkyl groups which are the same as or different from each other may be bonded to a Si atom. In a case where $R^W$ represents a trialkylsilyl group having other substituents in addition to an alkyl group, the substituents are not particularly limited.

In Formula (W), the total number of carbon atoms included in L and $R^W$ is preferably in a range of 5 to 18. When the total number of carbon atoms included in L and $R^W$ is greater than or equal to the lower limit of the above-described range, the carrier mobility is increased and the driving voltage is lowered. The total number of carbon atoms included in L and $R^W$ is less than or equal to the upper limit of the above-described range, the solubility in an organic solvent is increased.

The total number of carbon atoms included in L and $R^W$ is preferably in a range of 5 to 14, more preferably in a range of 6 to 14, particularly preferably in a range of 6 to 12, and more particularly preferably in a range of 8 to 12.

Among the substituents $R^C$ to $R^T$ in respective compounds represented by Formulae (C) to (T), the number of groups represented by Formula (W) is preferably in a range of 1 to 4 from the viewpoints of improving the carrier mobility and the solubility in an organic solvent, more preferably 1 or 2, and particularly preferably 2.

Among the substituents the $R^C$ to $R^T$, the positions of groups represented by Formula (W) are not particularly limited.

In the compound represented by Formula (C), a group in which any of $R^{C1}$, $R^{C2}$, $R^{C3}$, and $R^{C6}$ is represented by Formula (W) is preferable and a group in which both of $R^{C1}$ and $R^{C2}$ or both of $R^{C3}$ and $R^{C6}$ are represented by Formula (W) is more preferable.

In the compound represented by Formula (D), a group in which $R^{D6}$ is represented by Formula (W) is preferable and a group in which both of $R^{D5}$ and $R^{D6}$ are represented by Formula (W) is more preferable.

In the compound represented by Formula (E), a group in which $R^{E6}$ is represented by Formula (W) is preferable and a group in which both of $R^{E5}$ and $R^{E6}$ are represented by Formula (W) is more preferable. Further, in a case of a substituent other than the group in which both of $R^{E5}$ and $R^{E6}$ are represented by Formula (W), a group in which two $R^{E7}$'s are represented by Formula (W) is also preferable.

In the compound represented by Formula (F), a substituent in which at least one of $R^{F2}$, $R^{F3}$, $R^{F8}$, or $R^{F9}$ is represented by Formula (W) is preferable.

In the compound represented by Formula (G), a group in which $R^{G5}$ or $R^{G6}$ is represented by Formula (W) is preferable from the viewpoints of improving the carrier mobility and the solubility in an organic solvent.

In the compound represented by Formula (H), a group in which $R^{H4}$ or $R^{H6}$ is represented by Formula (W) is preferable and a group in which $R^{H4}$ or $R^{H6}$ and $R^{H3}$ or $R^{H5}$ are represented by Formula (W) is more preferable.

In the compound represented by Formula (J), a group in which $R^{J8}$ is represented by Formula (W) is preferable

and a group in which both of $R^{J8}$ and $R^{J4}$ are represented by Formula (W) is more preferable.

In the compound represented by Formula (K), a group in which $R^{K7}$ is represented by Formula (W) is preferable and a group in which both of $R^{K7}$ and $R^{K3}$ are represented by Formula (W) is more preferable.

In the compound represented by Formula (L), a group in which at least one of $R^{L2}$, $R^{L3}$, $R^{L6}$, or $R^{L7}$ is represented by Formula (W) is more preferable.

In the compound represented by Formula (M), a group in which $R^{M2}$ is represented by Formula (W) is preferable and a group in which both of $R^{M2}$ and $R^{M6}$ are represented by Formula (W) is more preferable.

In the compound represented by Formula (N), a group in which $R^{N3}$ is represented by Formula (W) is preferable and a group in which both of $R^{N3}$ and $R^{N9}$ are represented by Formula (W) is more preferable.

In the compound represented by Formula (P), a group in which $R^{P2}$ or $R^{P3}$ is represented by Formula (W) is preferable and a group in which both of $R^{P2}$ and $R^{P8}$ or both of $R^{P3}$ and $R^{P9}$ are represented by Formula (W) is more preferable.

In the compound represented by Formula (Q), a group in which $R^{Q3}$ is represented by Formula (W) is preferable and a group in which both of $R^{Q3}$ and $R^{Q9}$ are represented by Formula (W) is more preferable.

In the compound represented by Formula (R), a group in which $R^{R2}$ is represented by Formula (W) is preferable and a group in which both of $R^{R2}$ and $R^{R7}$ are represented by Formula (W) is more preferable.

In the compound represented by Formula (S), a group in which $R^{S2}$ is represented by Formula (W) is preferable and a group in which both of $R^{S2}$ and $R^{S5}$ are represented by Formula (W) is more preferable.

In the compound represented by Formula (T), a group in which $R^{T2}$ is represented by Formula (W) is preferable and a group in which both of $R^{T2}$ and $R^{T5}$ are represented by Formula (W) is more preferable.

Among the substituents $R^C$ to $R^T$, the number of substituents other than the groups represented by Formula (W) is preferably in a range of 0 to 4 and more preferably in a range of 0 to 2.

Hereinafter, specific examples of respective compounds represented by Formulae (C) to (T) will be described, but the compounds which can be used in the present invention should not be limitatively interpreted by these specific examples.

Specific examples of compounds C represented by Formula (C) are described.

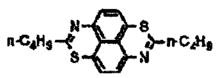

Compound C1

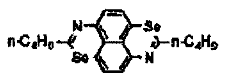

Compound C2

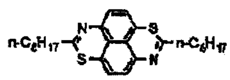

Compound C3

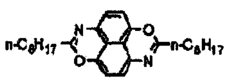

Compound C4

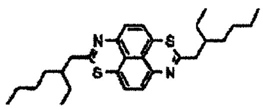

Compound C5

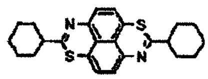

Compound C6

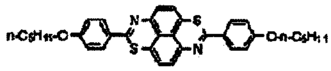

Compound C7

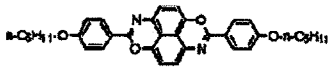

Compound C8

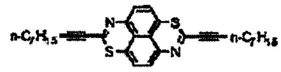

Compound C9

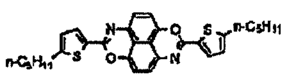

Compound C10

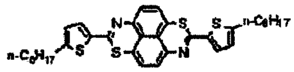

Compound C11

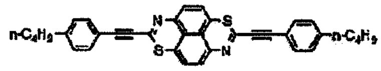

Compound C12

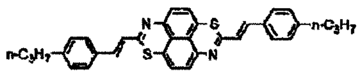

Compound C13

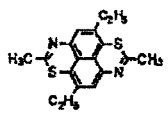

Compound C14

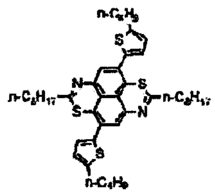

Compound C15

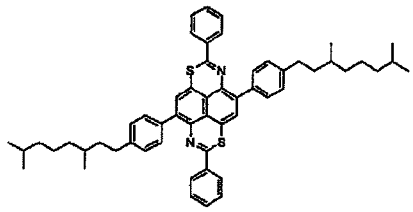

Compound C16

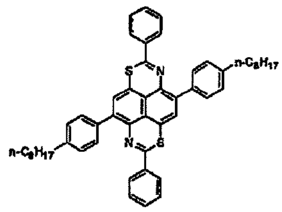

Compound C17

The molecular weight of a compound represented by Formula (C) is preferably 3000 or less, more preferably 2000 or less, still more preferably 1000 or less, and particularly preferably 850 or less. When the molecular weight is in the above-described range, the solubility in a solvent can be improved.

Meanwhile, from the viewpoint of stable film quality of a thin film, the molecular weight thereof is preferably 300 or greater, more preferably 350 or greater, and still more preferably 400 or greater.

Specific examples of compounds D represented by Formula (D) are described.

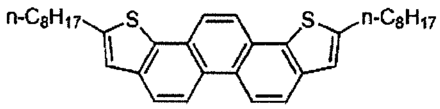

Compound D1

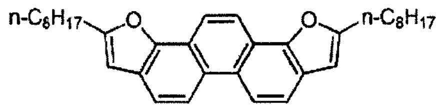

Compound D2

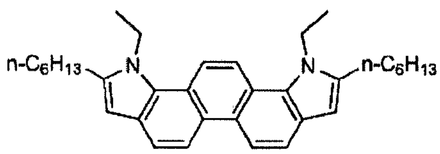

Compound D3

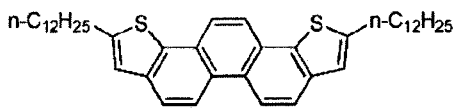

Compound D4

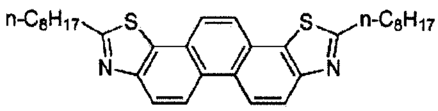

Compound D5

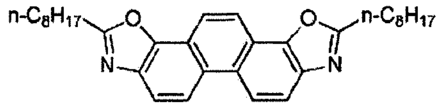

Compound D6

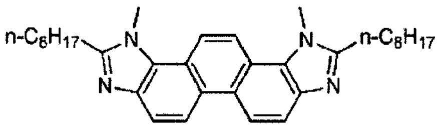

Compound D7

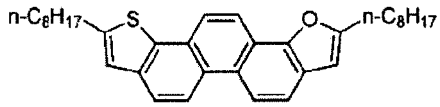

Compound D8

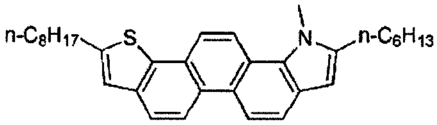

Compound D9

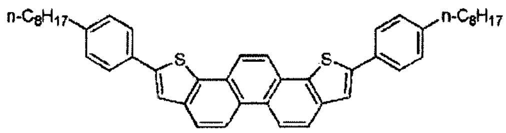

Compound D10

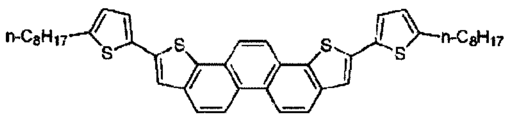

Compound D11

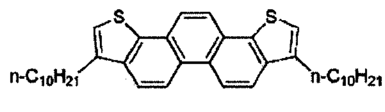

Compound D12

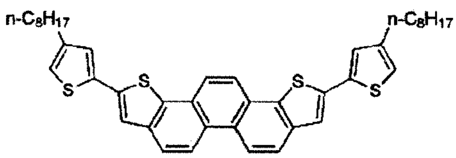

Compound D13

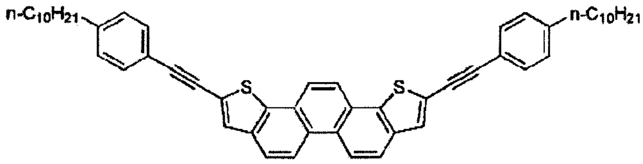

Compound D14

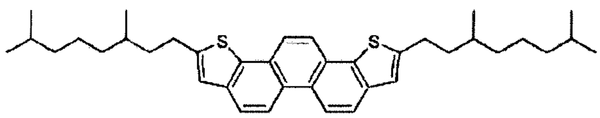

Compound D15

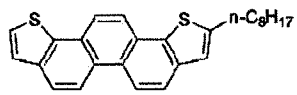

Compound D16

From the viewpoint of improving the solubility in a solvent, it is preferable that the upper limit of the molecular weight of a compound represented by Formula (D) is the same as that of the compound represented by Formula (C). Meanwhile, from the viewpoint of stable film quality of a thin film, the molecular weight thereof is preferably 400 or greater, more preferably 450 or greater, and still more preferably 500 or greater.

Specific examples of a compound E represented by Formula (E), a compound F represented by Formula (F), a compound G represented by Formula (G), and a compound H represented by Formula (H) are respectively described in order.

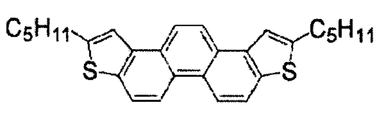

Compound E1

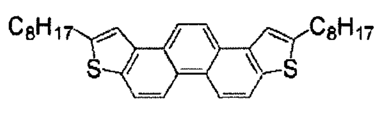

Compound E2

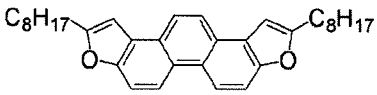

Compound E3

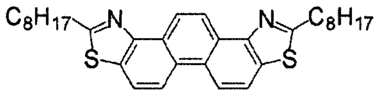

Compound E4

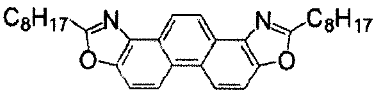

Compound E5

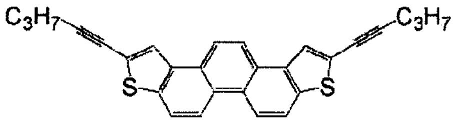

Compound E6

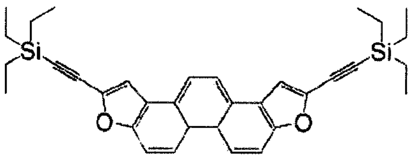

Compound E7

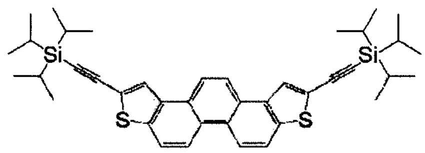

Compound E8

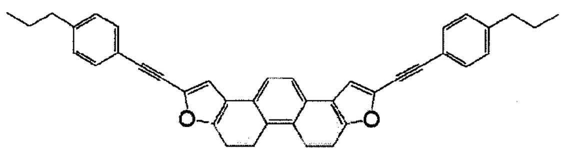

Compound E9

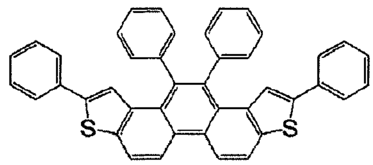

Compound E10

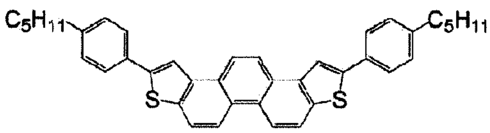

Compound E11

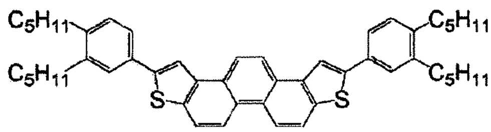

Compound E12

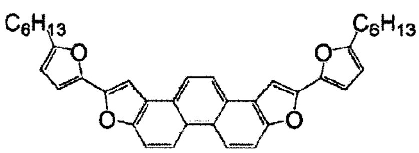

Compound E13

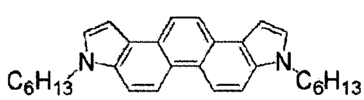

Compound E14

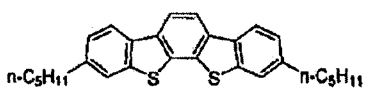

Compound F1

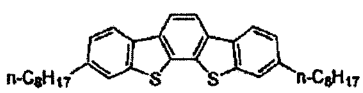

Compound F2

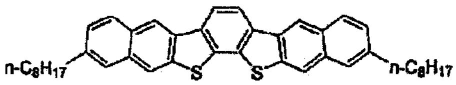
Compound F3

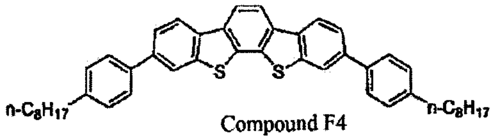
Compound F4

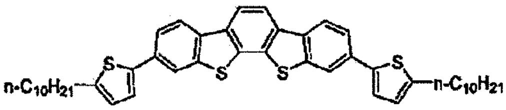
Compound F5

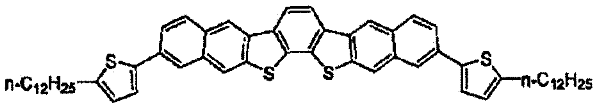
Compound F6

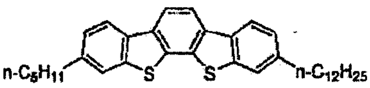
Compound F7

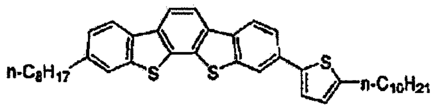
Compound F8

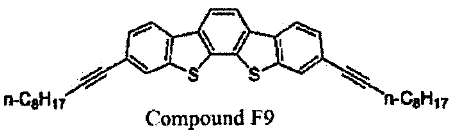
Compound F9

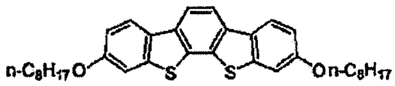
Compound F10

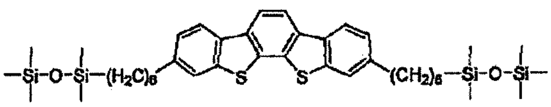
Compound F11

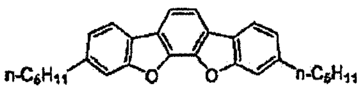
Compound F12

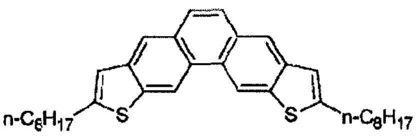
Compound G1

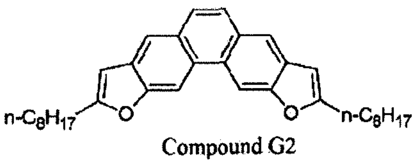
Compound G2

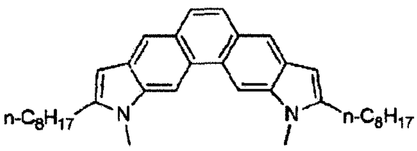
Compound G3

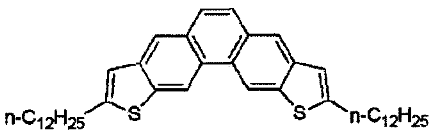
Compound G4

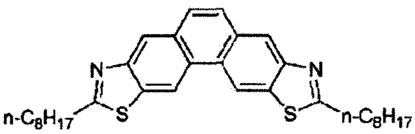
Compound G5

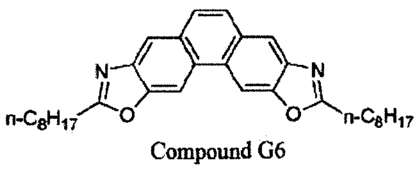
Compound G6

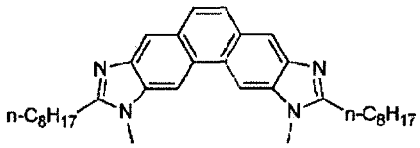

Compound G7

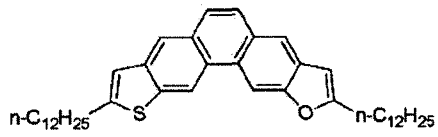

Compound G8

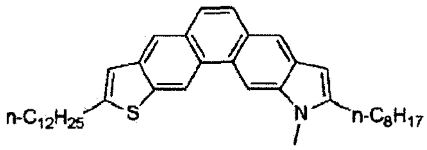

Compound G9

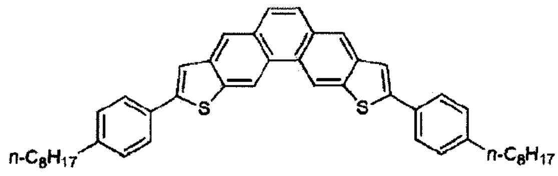

Compound G10

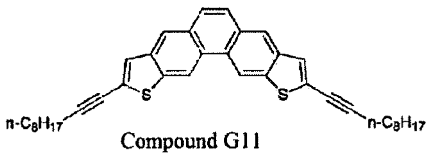

Compound G11

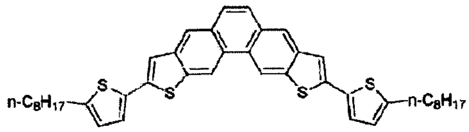

Compound G12

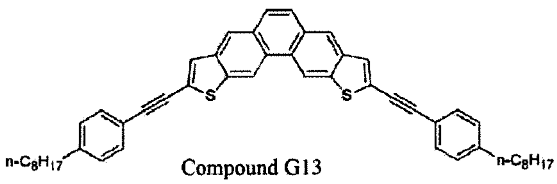

Compound G13

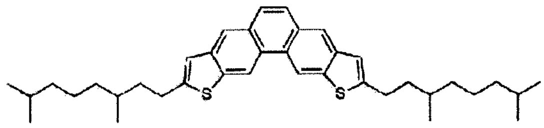

Compound G14

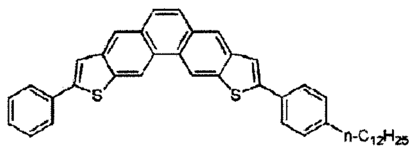

Compound G15

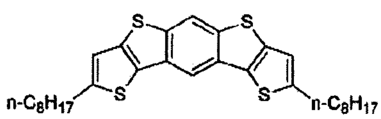

Compound H1

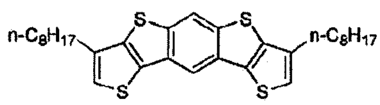

Compound H2

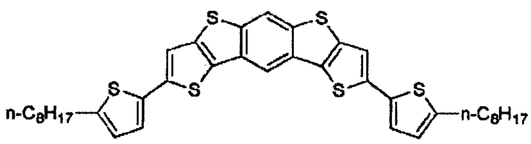

Compound H3

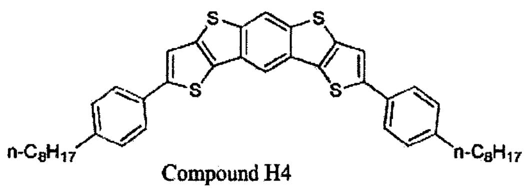

Compound H4

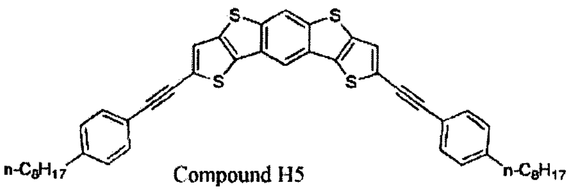

Compound H5

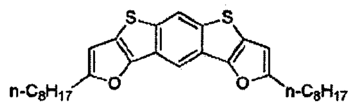

Compound H6

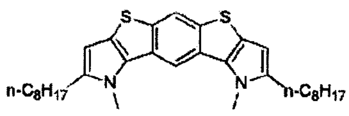

Compound H7

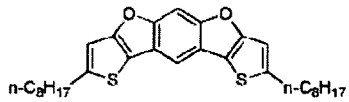

Compound H8

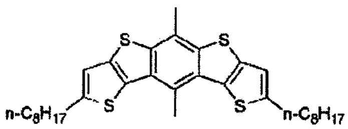

Compound H9

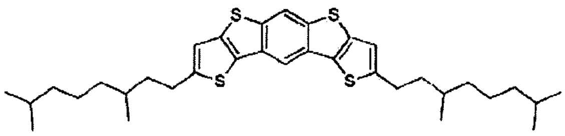

Compound H10

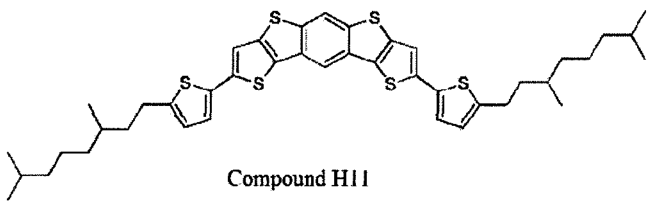

Compound H11

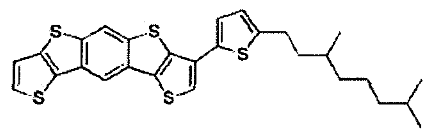

Compound H12

From the viewpoint of improving the solubility in a solvent, it is preferable that the upper limits of the molecular weights of the compounds E, F, G, and H are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound J represented by Formula (J) and a compound K represented by Formula (K) are described.

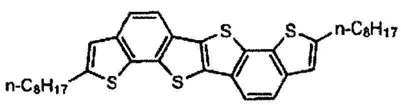

Compound J1

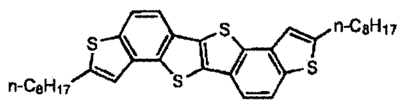

Compound K1

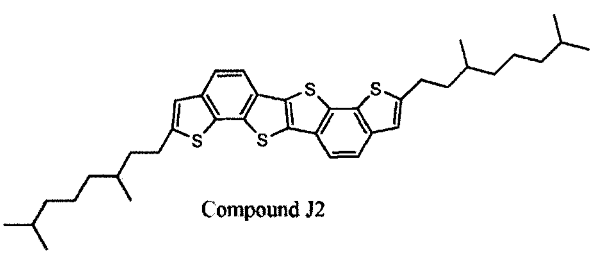

Compound J2

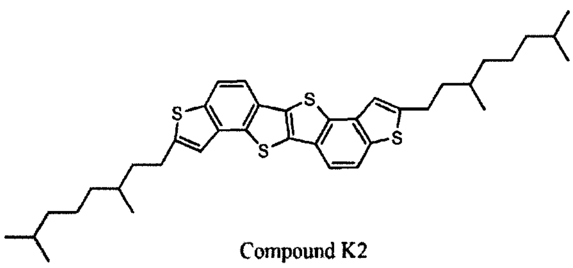

Compound K2

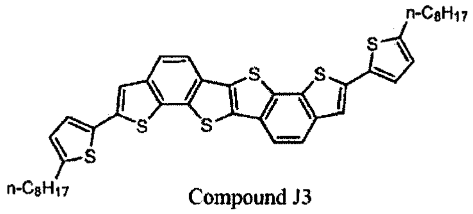

Compound J3

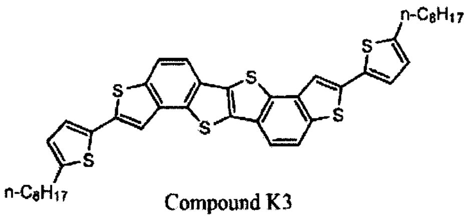

Compound K3

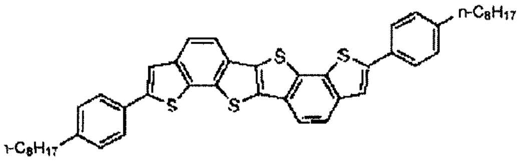

Compound J4

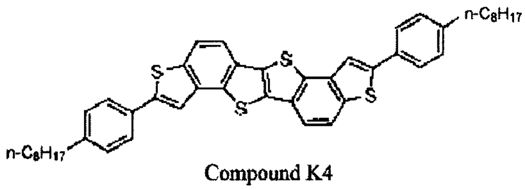

Compound K4

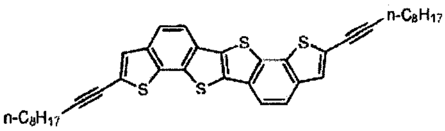

Compound J5

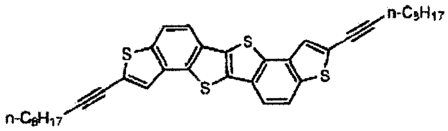

Compound K5

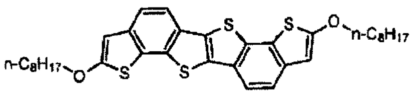

Compound J6

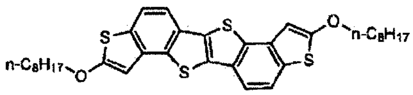

Compound K6

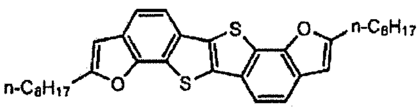

Compound J7

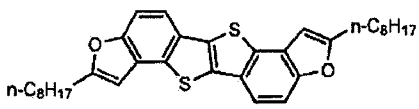

Compound K7

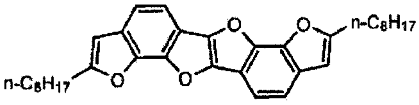

Compound J8

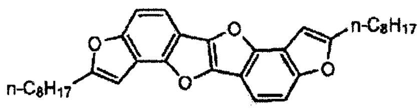

Compound K8

From the viewpoint of improving the solubility in a solvent, it is preferable that the upper limits of the molecular weights of the compounds J and K are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound L represented by Formula (L), a compound M represented by Formula (M), a compound N represented by Formula (N), a compound P represented by Formula (P), and a compound Q represented by Formula (Q) are respectively described in order.

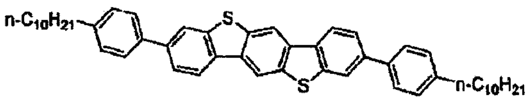

Compound L1

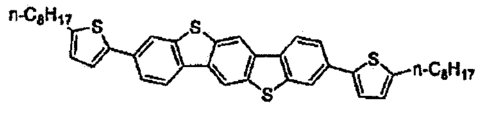

Compound L2

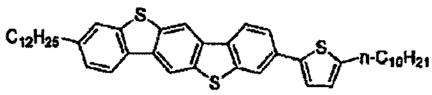

Compound L3

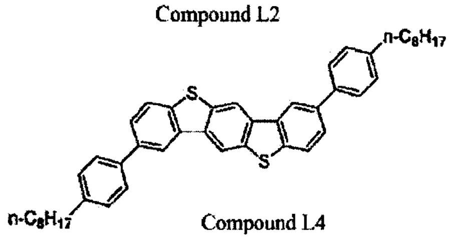

Compound L4

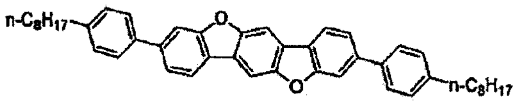

Compound L5

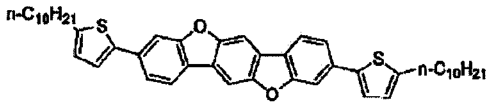

Compound L6

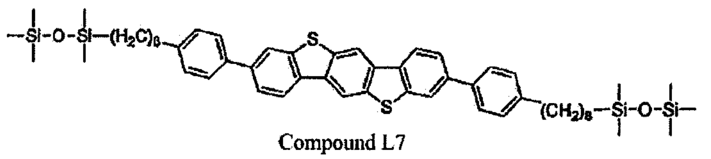

Compound L7

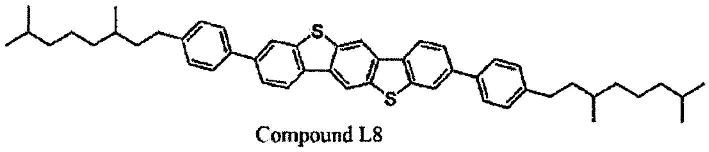

Compound L8

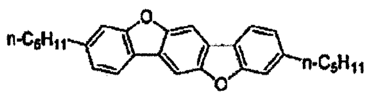

Compound L9

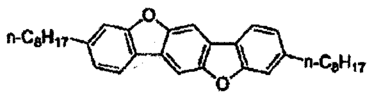

Compound L10

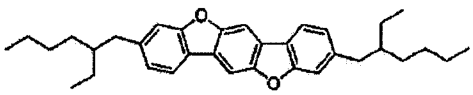

Compound L11

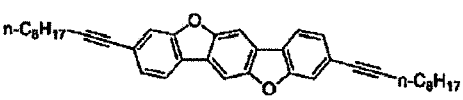

Compound L12

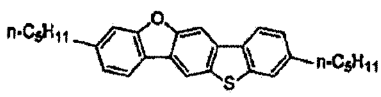

Compound L13

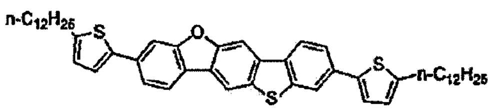

Compound L14

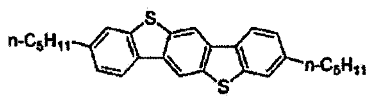

Compound L15

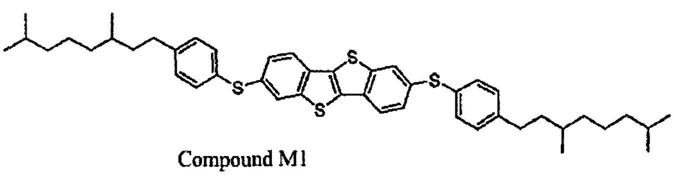

Compound M1

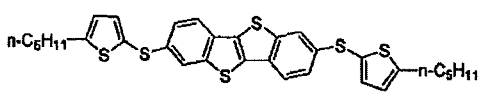

Compound M2

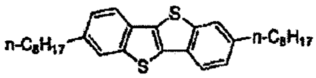

Compound M3
(C8BTBT)

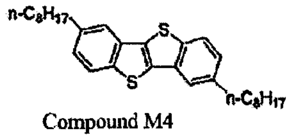

Compound M4

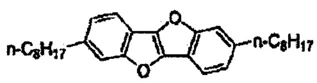

Compound M5

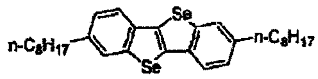

Compound M6

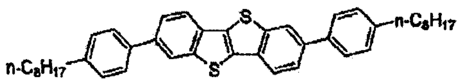

Compound M7

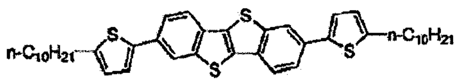

Compound M8

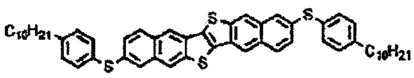

Compound N1

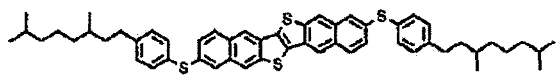

Compound N2

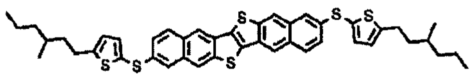

Compound N3

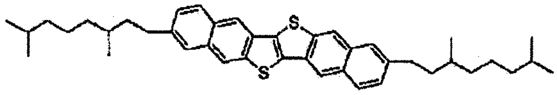

Compound N4

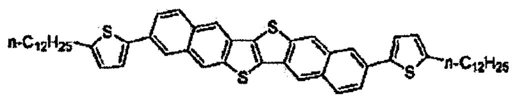

Compound N5

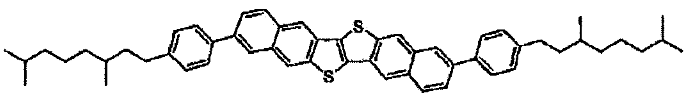

Compound N6

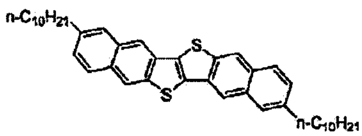

Compound N7

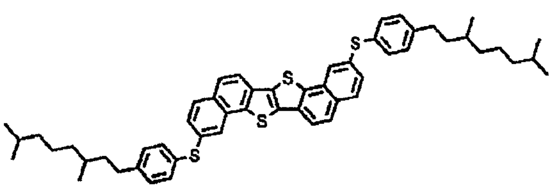

Compound P1

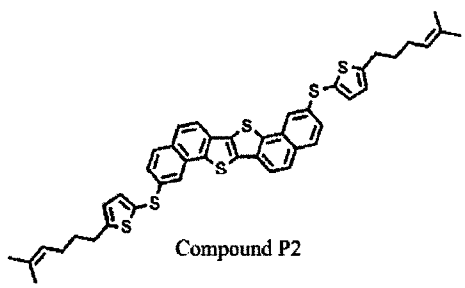

Compound P2

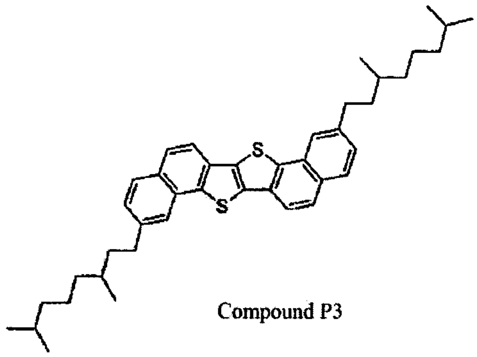

Compound P3

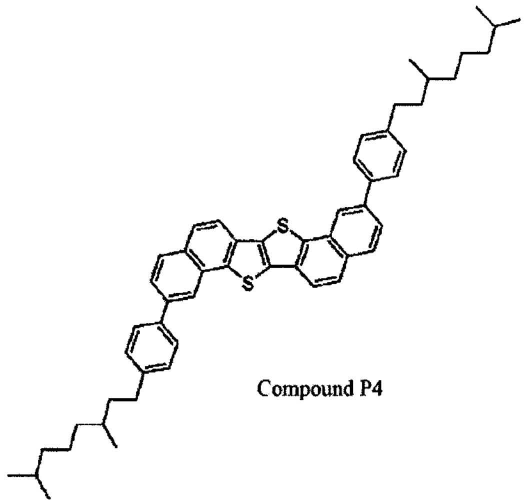

Compound P4

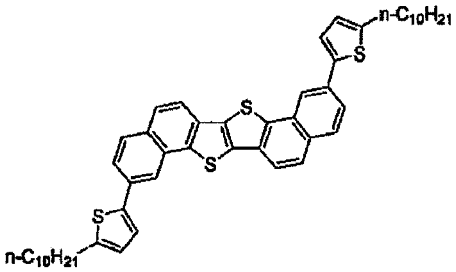

Compound P5

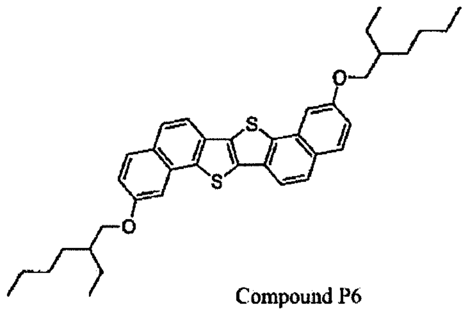

Compound P6

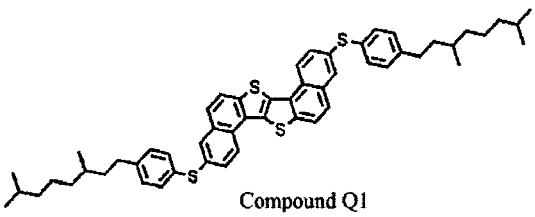

Compound Q1

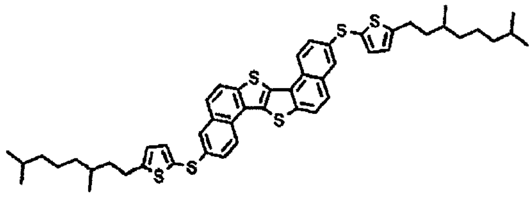

Compound Q2

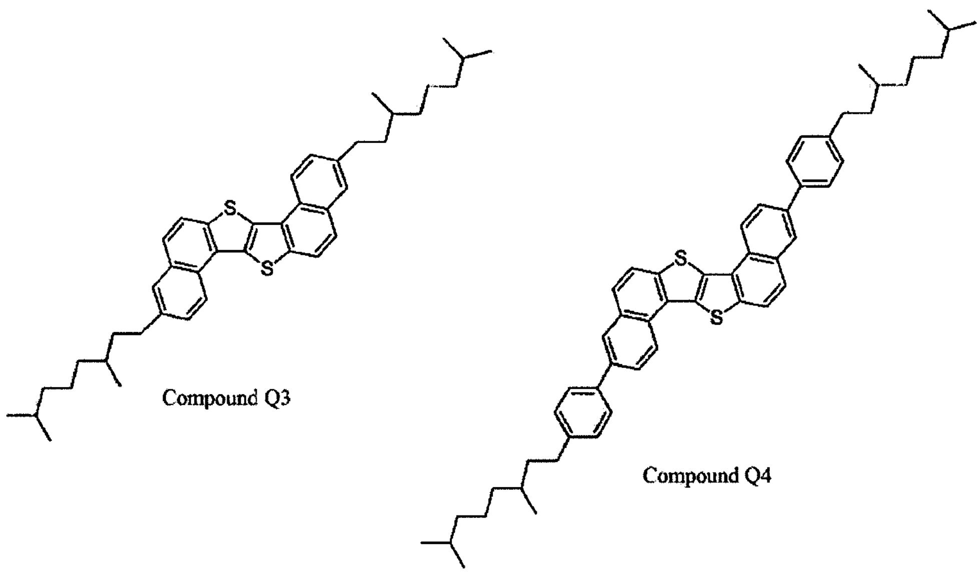

Compound Q3

Compound Q4

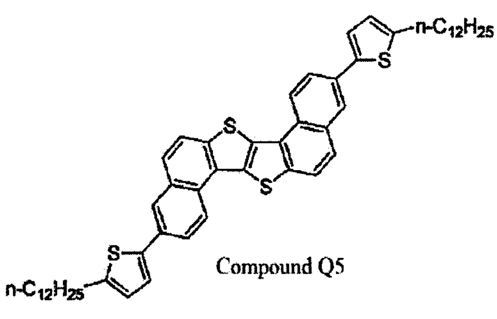

Compound Q5

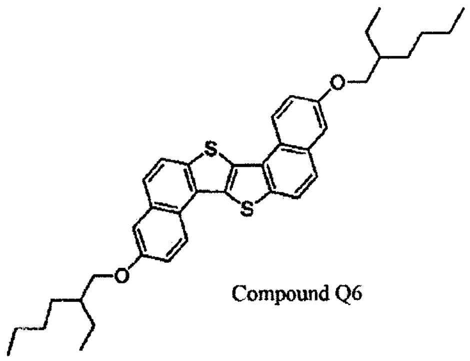

Compound Q6

From the viewpoint of improving the solubility in a solvent, it is preferable that the upper limits of the molecular weights of the compounds L, M, N, P, and Q are respectively the same as that of the compound C represented by Formula (C). Meanwhile, from the viewpoint of stable film quality of a thin film, the lower limits of the molecular weights thereof are respectively the same as that of the compound represented by Formula (D).

Specific examples of a compound R represented by Formula (R), a compound S represented by Formula (S), and a compound T represented by Formula (T) are respectively described in order.

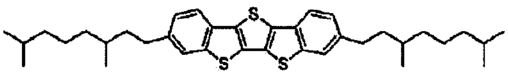

Compound R1

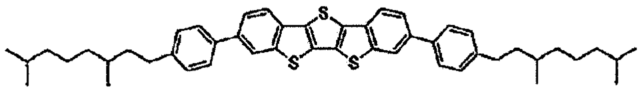

Compound R2

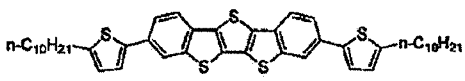

Compound R3

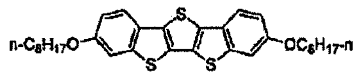

Compound R4

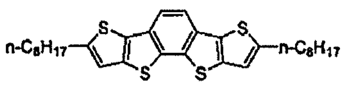

Compound S1

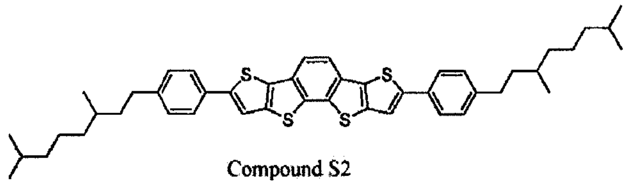

Compound S2

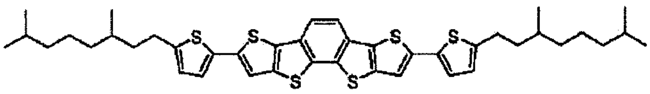

Compound S3

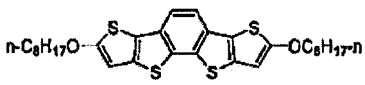

Compound S4

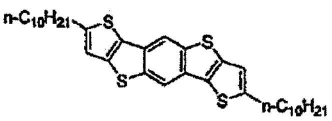

Compound T1

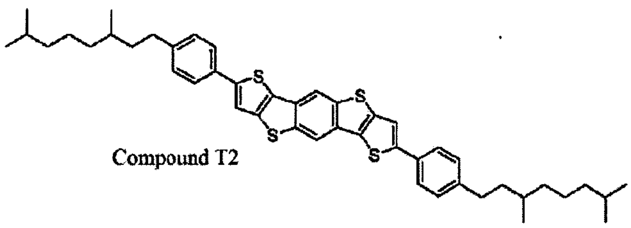

Compound T2

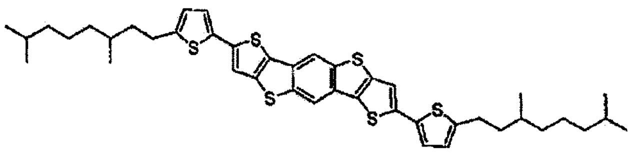

Compound T3

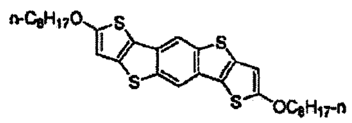

Compound T4

From the viewpoint of improving the solubility in a solvent, it is preferable that the upper limits of the molecular weights of the compounds R, S, and T are respectively the same as that of the compound C represented by Formula (C). Meanwhile, from the viewpoint of stable film quality of a thin film, the lower limits of the molecular weights thereof are respectively the same as that of the compound represented by Formula (D).

Examples of an organic polymer and a derivative thereof include polypyrrole and a derivative thereof, polydiketopyrrole and a derivative thereof, polythiophene and a derivative thereof, isothianaphthene such as polyisothianaphthene, thienylene vinylene such as polythienylene vinylene, poly(p-phenylenevinylene) such as poly(p-phenylenevinylene), polyaniline and a derivative thereof, polymers such as polyacetylene, polydiacetylene, polyazulene, polypyrene, polycarbazole, polyselenophene, polyfuran, poly(p-phenylene), polyindole, polypyridazine, polytellurophene, polynaphthalene, polyvinylcarbazole, polyphenylene sulfide, and polyvinylene sulfide, and a polymer of a condensed polycyclic aromatic compound.

The polythiophene and a derivative thereof are not particularly limited, and examples thereof include poly-3-hexylthiophene (P3HT) in which a hexyl group is introduced into polythiophene, polyethylene dioxythiophene, and poly(3,4-ethylenedioxythiophene)/polystyrenesulfonic acid (PEDOT/PSS).

Further, oligomers (such as oligothiophene) having repeating units which are the same as those of these polymers may also be exemplified.

Moreover, examples of the organic polymer include polymer compounds in which compounds represented by the following Formulae (C) to (T) have a repeating structure.

Examples of such polymers compound include $\pi$-conjugated polymers in which the compounds represented by Formulae (C) to (T) have a repeating structure through at least one or more arylene groups and heteroarylene groups (such as thiophene or bithiophene) and pendant type polymers in which the compounds represented by Formulae (C) to (T) are bonded to the polymer main chains through the side chains. Preferred examples of the polymer main chain include polyacrylate, polyvinyl, and polysiloxane and preferred examples of the side chain include an alkylene group and a polyethylene oxide group. In a case of the pendant type polymer, the polymer main chain may be formed by at least one of the substituents $R^C$, ..., or $R^T$ having a group derived from a polymerizable group to be polymerized.

The weight average molecular weight of these organic polymers is preferably 30000 or greater, more preferably 50000 or greater, and still more preferably 100000 or greater. When the weight average molecular weight is set to be the above-described lower limit or greater, intermolecular interaction can be increased so that high mobility is obtained.

[Source electrode and drain electrode]

In the OTFT of the present invention, a source electrode is an electrode into which a current from the outside flows through wiring. Further, a drain electrode is an electrode that sends the current to the outside through the wiring and is typically provided in contact with the above-described semiconductor layer.

As materials of the source electrode and the drain electrode, conductive materials used for organic thin-film transistors of the related art can be used, and examples thereof include the conductive materials described in the section of the gate electrode above.

The source electrode and the drain electrode can be respectively formed according to the same method as the method of forming the above-described gate electrode.

The above-described photolithography method, a lift-off method or an etching method can be employed.

Particularly, since the gate insulating layer has excellent resistance to an etching solution or a stripping solution, the source electrode and the drain electrode can be suitably formed even when an etching method is employed. The etching method is a method of removing unnecessary portions by etching after a film is formed using a conductive material. When patterning is performed according to the etching method, it is possible to prevent peeling of a conductive material remaining on a base at the time of removing a resist and to prevent re-attachment of resist residues or the removed conductive material to the base. Accordingly, the shape of an electrode edge portion is excellent. From this viewpoint, the etching method is preferred than the lift-off method.

The lift-off method is a method of coating a portion of a base with a resist, forming a film thereon with a conductive material, and eluting or peeling the resist and the like using a solvent so that the conductive material on the resist is entirely removed, and then forming a film of the conductive material only on the portion which is not coated with the resist.

The thicknesses of the source material and the drain material are optional, but are respectively preferably 1 nm or greater and particularly preferably 10 nm or greater. Further, the thickness thereof is preferably 500 nm or less and particularly preferably 300 nm or less.

The space (channel length) between the source electrode and the drain electrode is optional, but is preferably 100 μm or less and particularly preferably 50 μm or less. Further, the channel width thereof is preferably 5000 μm or less and particularly preferably 1000 μm or less.

[Overcoat layer]

The OTFT of the present invention may have an overcoat layer. The overcoat layer is typically a layer formed on the surface of an OTFT as a protective layer. The overcoat layer may have a single-layer structure or a multi-layer structure.

The overcoat layer may be organic or inorganic.

The material forming an organic overcoat layer is not particularly limited, and examples thereof include organic polymers such as polystyrene, an acrylic resin, polyvinyl alcohol, polyolefin, polyimide, polyurethane, polyacetylene, and an epoxy resin, and derivatives obtained by introducing a crosslinkable group or a water-repellent group into these organic polymers. These organic polymers or derivatives thereof can be also used in combination with a crosslinking component, a fluorine compound, or a silicon compound.

The material forming an inorganic overcoat layer is not particularly limited, and examples thereof include metal oxides such as silicon oxide and aluminum oxide, and metal nitrides such as silicon nitride.

These materials may be used alone or in combination of optional two or more kinds thereof at an optional ratio.

A method of forming an overcoat layer is not limited and an overcoat layer can be formed according to known various methods.

For example, an organic overcoat layer can be formed using a method of coating an underlayer with a solution containing a material which becomes the overcoat layer, drying the layer, exposing the layer to light, and developing the layer to be patterned. Moreover, the patterning of the overcoat layer can be directly formed using a printing method or an ink-jet method. In addition, after the overcoat layer is patterned, the overcoat layer may be cross-linked by being exposed to light or heated.

Meanwhile, an inorganic overcoat layer can be formed using a dry method such as a sputtering method or a vapor deposition method or a wet method such as a sol-gel method.

[Other layers]

The OTFT of the present invention may be provided with other layers or members.

As other layers or members, a bank may be exemplified. A bank is used for the purpose of holding a discharge liquid in a predetermined position when a semiconductor layer or an overcoat layer is formed using an ink-jet method. For this reason, a bank typically has liquid repellency. Examples of forming a bank include a method of performing a liquid repellent treatment such as a fluorine plasma method after patterning is performed according to a photolithography method or the like and a method of curing a photosensitive composition or the like containing liquid repellent components such as a fluorine compound.

In a case of the organic thin-film transistor of the present invention, since a gate insulating layer is an organic layer, the latter method of curing a photosensitive composition containing liquid repellent components is preferable from the viewpoint that the gate insulating layer is not affected by the liquid repellent treatment. In addition, a technique of allowing a base to have a contrast of liquid repellency without using a bank so that the base plays the same role as that of a bank may be used.

[Use of OTFT]

It is preferable that the OTFT of the present invention is mounted on a display panel for use. Examples of the display panel include a liquid crystal panel, an organic EL panel, and an electron paper panel.

Examples

Hereinafter, the present invention will be described in detail based on examples, but the present invention is not limited to those examples.

[Preparation Example 1] Preparation of top-gate type OTFT-1

<Substrate>

A top-gate bottom-contact type OTFT illustrated in Fig. 1A was prepared. A glass substrate having a thickness of 1.1 mm was coated with a polyimide-based alignment film solution (SE-130, polyimide precursor solution, manufactured by Nissan Chemical Industries, Ltd.) diluted to 2 wt% using N-methyl-2-pyrrolidone, and then the glass electrode was dried at 100°C for 10 minutes. Thereafter, a polyimide film (thickness: 100 nm) was obtained by performing imidization at 230°C for 2 hours. The surface of this film was subjected to a rubbing treatment (alignment treatment) using cotton cloth, and a substrate 6 whose surface was subjected to an alignment treatment was obtained.

<Alignment layer>

Coating solutions having a solid content concentration of 10 wt% were prepared by dissolving polymerizable liquid crystalline compounds (liquid crystalline monomers) described below and IRGACURE 907 as a polymerization initiator in methyl ethyl ketone. The content of IRGACURE 907 in the coating solutions was set to 3 parts by mass with respect to 100 parts by mass of the polymerizable liquid crystalline compounds. Further, surfactants (air interface alignment control agents) listed in the following table were added to some coating solutions such that the contents of the surfactants became 0.5 parts by mass with respect to 100 parts by mass of the liquid crystalline monomers in the coating solutions.

The surface of the substrate 6 subjected to a rubbing treatment was spin-coated with the obtained coating solutions (2000 rotations for 10 seconds). Subsequently, the alignment of the polymerizable liquid crystalline compounds was allowed to be aged by heating the surface thereof at 110°C. Next, the polymerizable liquid crystalline compounds were polymerized by irradiating the surface with ultraviolet rays (integrated amount of irradiation: 500 mJ/$cm^2$, 10 seconds) at a temperature of 60°C or 140°C to immobilize the aligned state, thereby forming an alignment layer 7 (thickness: 220 nm). Moreover, in the case of the coating solutions to which the surfactant was added, the alignment layer 7 was immersed in a methyl ethyl ketone solution after the polymerization reaction and washed with ultrasonic waves, and then the surfactant was removed from the alignment layer 7.

In addition, the "state of a liquid crystal phase before the polymerization reaction" in the following table when the alignment layer was formed was evaluated by observing the optical texture using a polarizing microscope. Further, the "aligned state of the surface of the alignment layer on the organic semiconductor layer side" after the polymerization reaction (after polymerization and immobilization) was evaluated by measuring the retardation according to a Senarmont method.

Liquid crystalline monomer a (discotic)

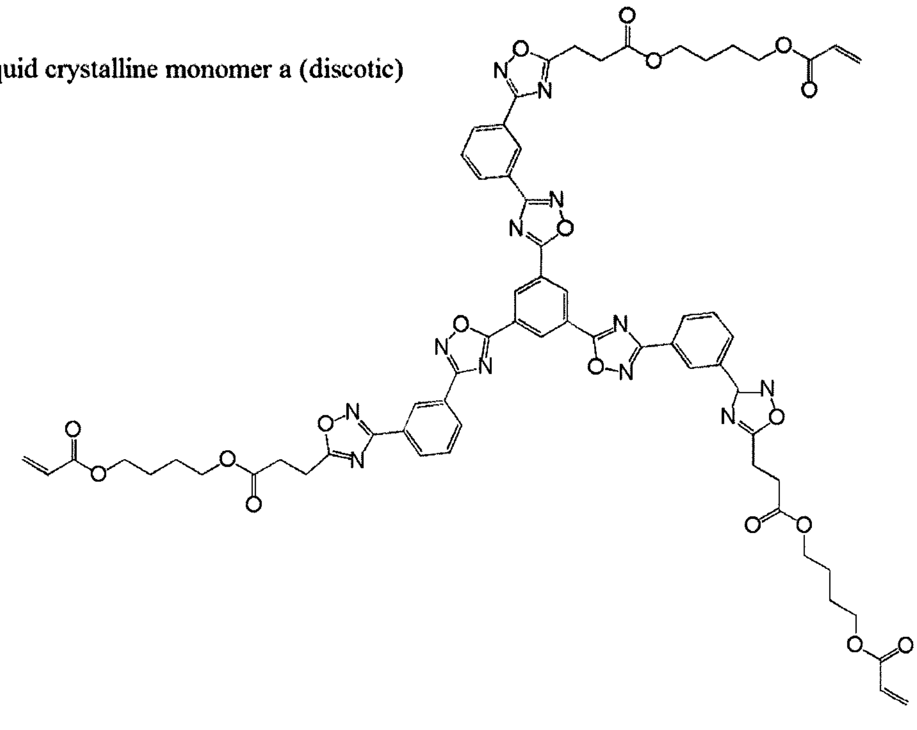

Liquid crystalline monomer b (rod-like)

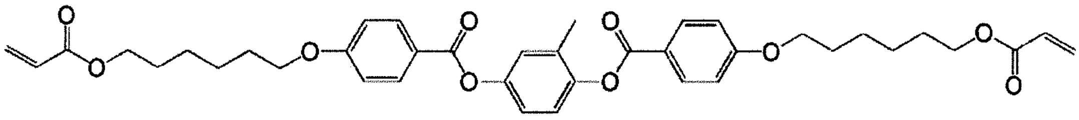

[Table 1]

| Alignment layer | Polymerizable liquid crystalline compound | Surfactant | State of liquid crystal phase before polymerization reaction | Temperature of polymerization reaction (°C) | Aligned state of surface on organic semiconductor layer side after polymerization reaction |
|---|---|---|---|---|---|
| X1 | Liquid crystalline monomer a | Surfactant a | Discotic nematic | 60 | Horizontal alignment |
| X2 | Liquid crystalline monomer a | None | | 60 | Vertical alignment |
| X3 | Liquid crystalline monomer a | Surfactants a and b | | 60 | Oblique alignment |
| X4 | Liquid crystalline monomer a | None | Isotropic phase | 140 | Not aligned |
| X5 | Liquid crystalline monomer b | Surfactant a | Nematic | 60 | Horizontal alignment |

Surfactant a

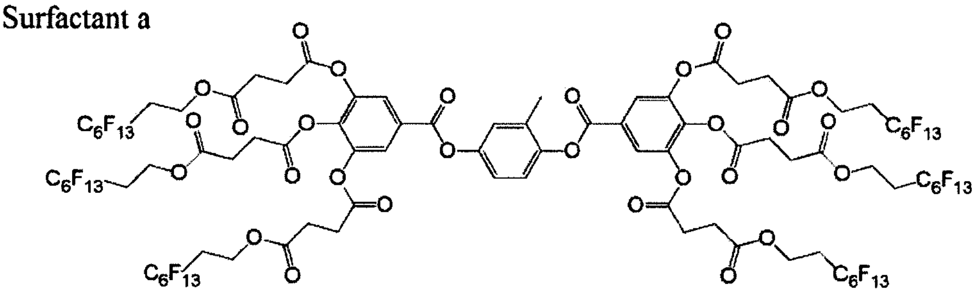

Surfactant b

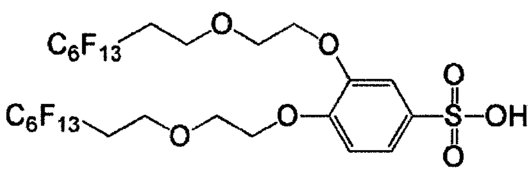

<Source electrode and drain electrode>

Gold was subjected to vacuum vapor deposition on the alignment layer 7 formed as described above, thereby

preparing a source electrode 3 and a drain electrode 4 having a channel length of 30 μm, a channel width of 10 mm, and a thickness of 50 nm.

<Organic semiconductor layer>

Toluene solutions obtained by dissolving organic semiconductors described below therein at a concentration of 0.5 wt% were prepared. A space between the source electrode and the drain electrode was spin-coated (500 rotations for 20 seconds and 1000 rotations for 20 seconds) with the solutions and organic semiconductor layers 1 were formed such that the layer thickness after drying was set to 150 nm.

Organic semiconductor a

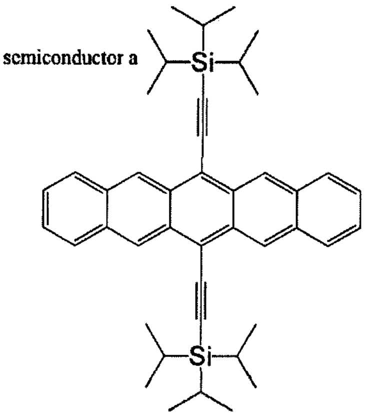

Organic semiconductor b

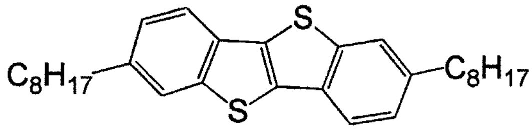

Organic semiconductor c

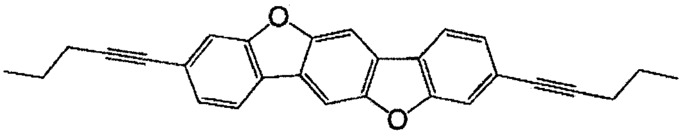

Organic semiconductor d

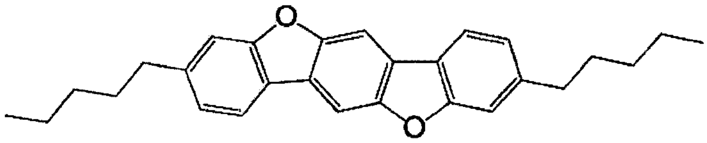

Organic semiconductor c

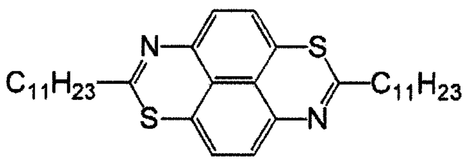

<Gate insulating layer>

The source electrode 3, the drain electrode 4, and the organic semiconductor 1 were spin-coated with Cytop CTL-809M (solid content concentration: 9 wt%, manufactured by ASAHI GLASS CO., LTD.) such that the source electrode, the drain electrode, and the organic semiconductor were covered by Cytop CTL-809M and dried at 150°C, the solvent was removed, and then a gate insulating layer 2 (thickness: 200 nm) was formed.

<Gate electrode>

Gold was subjected to vacuum vapor deposition on the gate insulating layer 2 and a gate electrode 5 (thickness:

50 nm) was formed, thereby obtaining a top-gate type OTFT.

OTFTs having alignment layers X1 to X5 are respectively referred to as OTFTs Xt1 to Xt5.

[Preparation Example 2] Preparation of top-gate type OTFT -2

An OTFT was prepared in the same manner as in Preparation Example 1 except that the source electrode, the drain electrode, and the organic semiconductor layer were prepared directly on the substrate (substrate was not subjected to a rubbing treatment) without forming the alignment layer in Preparation Example 1. The obtained OTFT is referred to as an OTFT Yt1.

[Test Example 1] Evaluation of performance of OTFT-1

The carrier mobilities of the OTFTs obtained in the above-described respective preparation examples were evaluated according to the following method.

A voltage of -40 V was applied to a space between the source electrode and the drain electrode so that the gate voltage was changed to be in a range of 40 V to -40 V, and a carrier mobility $\mu$ was calculated using the following equation representing a drain current Id.

$$Id = (w/2L)\mu Ci(Vg - Vth)^2$$

(In the equation, L represents the gate length, w represents the gate width, Ci represents the capacity per unit area of the insulating layer, Vg represents the gate voltage, and Vth represents the threshold voltage)

The obtained carrier mobilities were evaluated based on the following evaluation standard.

(Evaluation standard of carrier mobility)

A: The carrier mobility was 0.05 $cm^2/Vs$ or greater.
B: The carrier mobility was 0.025 $cm^2/Vs$ or greater and less than 0.05 $cm^2/Vs$.
C: The carrier mobility was 0.01 $cm^2/Vs$ or greater and less than 0.25 $cm^2/Vs$.
D: The carrier mobility was 0.005 $cm^2/Vs$ or greater and less than 0.01 $cm^2/Vs$.
E: The carrier mobility was less than 0.005 $cm^2/Vs$.

The results are listed in the following Table 2.

[Table 2]

| OTFT | Example/Comparative Example | Alignment layer | Organic semiconductor layer | | | | |
|---|---|---|---|---|---|---|---|
| | | | Organic semiconductor a | Organic semiconductor b | Organic semiconductor c | Organic semiconductor d | Organic semiconductor e |
| Xt1 | Example | X1 | A | A | A | A | A |
| Xt2 | Example | X2 | A | A | A | A | A |
| Xt3 | Example | X3 | A | A | A | A | A |
| Xt4 | Comparative Example | X4 | D | D | D | D | D |
| Xt5 | Comparative Example | X5 | C | C | C | C | C |
| Yt1 | Comparative Example | None | E | E | E | E | E |

As shown from the above-described Table 2, the carrier mobilities or the OTFT Xt4 prepared by providing an organic semiconductor layer on the alignment layer without aligning a discotic liquid crystalline compound and the OTFT Yt1 prepared by providing an organic semiconductor layer directly on the substrate without providing an alignment layer were significantly low. Further, the carrier mobility of the OTFT Xt5 using a rod-like liquid crystalline compound for the alignment layer was also significantly low regardless of the rod-like liquid crystalline compound being aligned in the alignment layer.

Meanwhile, the carrier mobilities of the OTFTs Xt1 to Xt3 in which a discotic liquid crystalline compound was used for the alignment layer and the discotic liquid crystalline compound was aligned were all excellent.

Explanation of References

1: organic semiconductor layer

2: gate insulating layer

3: source electrode

4: drain electrode

5: gate electrode

6: substrate

7: alignment layer

## Claims

1. A top gate type organic thin-film transistor comprising:

   a substrate;
   an alignment layer provided on the substrate;
   an organic semiconductor layer provided on the alignment layer;
   a gate insulating layer provided on the organic semiconductor layer;
   a gate electrode provided on the gate insulating layer; and
   a source electrode and a drain electrode provided in contact with the organic semiconductor layer and connected to each other through the organic semiconductor layer,
   wherein the organic semiconductor layer contains a condensed polycyclic aromatic compound having a molecular weight of 300 to 2000,
   **characterized in that**, the alignment layer comprises an aligned discotic liquid crystalline compound.

2. The organic thin-film transistor according to claim 1,
   wherein the discotic liquid crystalline compound is a polymerizable discotic liquid crystalline compound, and the alignment layer contains the polymerized and immobilized discotic liquid crystalline compound.

3. The organic thin-film transistor according to claim 1 or 2,
   wherein the discotic liquid crystalline compound forms a discotic nematic phase in the alignment layer.

4. The organic thin-film transistor according to any one of claims 1 to 3,
   wherein the discotic liquid crystalline compound is horizontally aligned on the surface of the alignment layer on the organic semiconductor layer side.

5. The organic thin-film transistor according to any one of claims 1 to 3,
   wherein the discotic liquid crystalline compound is vertically aligned on the surface of the alignment layer on the organic semiconductor layer side.

**6.** The organic thin-film transistor according to any one of claims 1 to 3, wherein the discotic liquid crystalline compound is obliquely aligned on the surface of the alignment layer on the organic semiconductor layer side.

## Patentansprüche

**1.** Organischer Dünnfilmtransistor vom Top-Gate-Typ, enthaltend:

ein Substrat,
eine auf dem Substrat vorgesehene Ausrichtungsschicht,
eine auf der Ausrichtungsschicht vorgesehene organische Halbleiterschicht,
eine Gate-Isolationsschicht, die auf der organischen Halbleiterschicht vorgesehen ist,
eine Gate-Elektrode, die auf der Gate-Isolationsschicht vorgesehen ist, und
eine Source-Elektrode und eine Drain-Elektrode, die in Kontakt mit der organischen Halbleiterschicht vorgesehen sind und aneinander durch die organische Halbleiterschicht verbunden sind,
worin die organische Halbleiterschicht eine kondensierte polycyclische aromatische Verbindung mit einem Molekulargewicht von 300 bis 2.000 enthält, **dadurch gekennzeichnet, dass** die Ausrichtungsschicht eine ausgerichtete diskotische flüssigkristalline Verbindung enthält.

**2.** Organischer Dünnfilmtransistor gemäß Anspruch 1, worin die diskotische flüssigkristalline Verbindung eine polymerisierbare diskotische flüssigkristalline Verbindung ist und die Ausrichtungsschicht die polymerisierte und immobilisierte diskotische flüssigkristalline Verbindung enthält.

**3.** Organischer Dünnfilmtransistor gemäß Anspruch 1 oder 2, worin die diskotische flüssigkristalline Verbindung eine diskotische nematische Phase in der Ausrichtungsschicht bildet.

**4.** Organischer Dünnfilmtransistor gemäß einem der Ansprüche 1 bis 3, worin die diskotische flüssigkristalline Verbindung horizontal auf der Oberfläche der Ausrichtungsschicht auf der Seite der organischen Halbleiterschicht ausgerichtet ist.

**5.** Organischer Dünnfilmtransistor gemäß einem der Ansprüche 1 bis 3, worin die diskotische flüssigkristalline Verbindung vertikal auf der Oberfläche der Ausrichtungsschicht auf der Seite der organischen Halbleiterschicht ausgerichtet ist.

**6.** Organischer Dünnfilmtransistor gemäß einem der Ansprüche 1 bis 3, worin die diskotische flüssigkristalline Verbindung schräg auf der Oberfläche der Ausrichtungsschicht auf der Seite der organischen Halbleiterschicht ausgerichtet ist.

## Revendications

**1.** Transistor à film mince organique du type à grille supérieure comprenant :

un substrat ;
une couche d'alignement prévue sur le substrat ;
une couche semiconductrice organique prévue sur la couche d'alignement ;
une couche d'isolation de grille prévue sur la couche semiconductrice organique ;
une électrode de grille prévue sur la couche d'isolation de grille ; et
une électrode de source et une électrode de drain prévues en contact avec la couche semiconductrice organique et connectées l'une à l'autre à travers la couche semiconductrice organique,
dans lequel la couche semiconductrice organique contient un composé aromatique polycyclique condensé ayant un poids moléculaire de 300 à 2000,
**caractérisé en ce que**, la couche d'alignement comprend un composé cristallin liquide discotique aligné.

**2.** Transistor à film mince organique selon la revendication 1, dans lequel le composé cristallin liquide discotique est un composé cristallin liquide discotique polymérisable, et la couche d'alignement contient le composé cristallin liquide discotique polymérisé et immobilisé.

3. Transistor à film mince organique selon la revendication 1 ou 2, dans lequel le composé cristallin liquide discotique forme une phase nématique discotique dans la couche d'alignement.

4. Transistor à film mince organique selon l'une quelconque des revendications 1 à 3, dans lequel le composé cristallin liquide discotique est aligné horizontalement sur la surface de la couche d'alignement sur le côté de la couche semiconductrice organique.

5. Transistor à film mince organique selon l'une quelconque des revendications 1 à 3, dans lequel le composé cristallin liquide discotique est aligné verticalement sur la surface de la couche d'alignement sur le côté de la couche semiconductrice organique.

6. Transistor à film mince organique selon l'une quelconque des revendications 1 à 3, dans lequel le composé cristallin liquide discotique est aligné obliquement sur la surface de la couche d'alignement sur le côté de la couche semiconductrice organique.

FIG. 1A

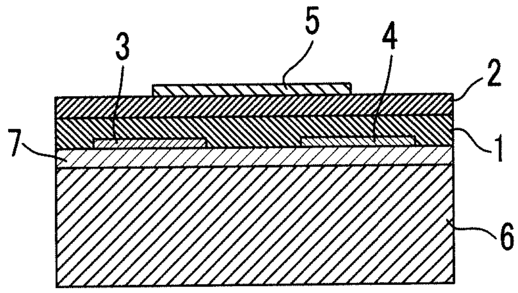


FIG. 1B

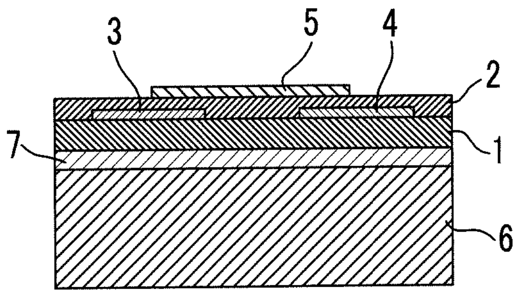

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006261339 A
- JP 2005072200 A
- JP 8027284 A
- JP H827284 A
- JP 2009097002 A
- JP 2007108732 A
- JP 11352328 A
- JP H11352328 A
- JP 2002020363 A
- JP 2001330725 A
- JP 2005179636 A
- JP 8095030 A
- JP H895030 A
- US 2367661 A
- US 2367670 A
- US 2448828 A
- US 2722512 A
- US 3046127 A
- US 2951758 A
- US 3549367 A
- JP 60105667 A
- JP S60105667 A
- US 4239850 A
- US 4212970 A
- JP 2013214649 A
- JP 2011186069 A
- JP 2010285518 A
- JP 2012163946 A
- JP 2005354012 A
- JP 2006303465 A


### Non-patent literature cited in the description


- Handbook of Liquid Crystal. MARUZEN Co., Ltd, 30 October 2000, 226-229
- **C. DESTRADE et al.** *Mol. Crysr. Liq. Cryst.,* 1981, vol. 71, 111
- liquid crystal chemistry. 1994
- **B. KOHNE et al.** *Angew. Chem. Soc. Chem. Comm.,* 1985, 1794
- **J. ZHANG et al.** *J. Am. Chem. Soc.,* 1994, vol. 116, 2655